(19) Europäisches Patentamt
European Patent Office
Office européen des brevets

(11) EP 3 379 587 A1

(12) EUROPEAN PATENT APPLICATION
published in accordance with Art. 153(4) EPC

(43) Date of publication:
**26.09.2018 Bulletin 2018/39**

(21) Application number: **16866335.9**

(22) Date of filing: **16.11.2016**

(51) Int Cl.:
***H01L 33/60*** *(2010.01)* ***C08K 3/22*** *(2006.01)*
***C08K 5/00*** *(2006.01)* ***C08K 5/13*** *(2006.01)*
***C08K 5/524*** *(2006.01)* ***C08K 5/5393*** *(2006.01)*
***C08K 7/14*** *(2006.01)* ***C08L 67/02*** *(2006.01)*

(86) International application number:
**PCT/JP2016/083927**

(87) International publication number:
**WO 2017/086334 (26.05.2017 Gazette 2017/21)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **16.11.2015 JP 2015224128**

(71) Applicant: **Kuraray Co., Ltd.**
**Kurashiki-shi, Okayama 710-0801 (JP)**

(72) Inventors:
- **KANAI, Shimon**
**Tsukuba-shi**
**Ibaraki 305-0841 (JP)**
- **OYA, Nobuhiro**
**Tsukuba-shi**
**Ibaraki 305-0841 (JP)**
- **SHIGEMATSU, Takaharu**
**Tsukuba-shi**
**Ibaraki 305-0841 (JP)**

(74) Representative: **Müller-Boré & Partner Patentanwälte PartG mbB**
**Friedenheimer Brücke 21**
**80639 München (DE)**

# (54) POLYESTER COMPOSITION FOR LED REFLECTIVE PLATES, LED REFLECTIVE PLATE, AND LIGHT EMITTING DEVICE EQUIPPED WITH SAID REFLECTIVE PLATE

(57) The present invention relates to a polyester composition for an LED reflection plate containing a polyester (A), a titanium oxide (B), a phenolic antioxidant (C), and a phosphorus-based antioxidant (D), wherein the polyester (A) is a polyester having a structural unit derived from a dicarboxylic acid including 50 mol% or more of terephthalic acid and a structural unit derived from a diol including 50 mol% or more of 1,4-cyclohexanedimethanol; the phosphorus-based antioxidant (D) contains three or more groups represented by the formula (1) in a molecule thereof, the content of the titanium oxide (B) is 20 to 90 parts by mass, and the content of the phenolic antioxidant (C) is 0.1 to 0.8 parts by mass, on the basis of 100 parts by mass of the polyester (A); and the content of the phosphorus-based antioxidant (D) satisfies the following equation (I); an LED reflection plate composed of the foregoing composition; and a light-emitting device including the foregoing reflection plate.

$$0.20 \leq \text{mass ratio [component (C)/component (D)]} \leq 5.00 \qquad \text{(I)}$$

EP 3 379 587 A1

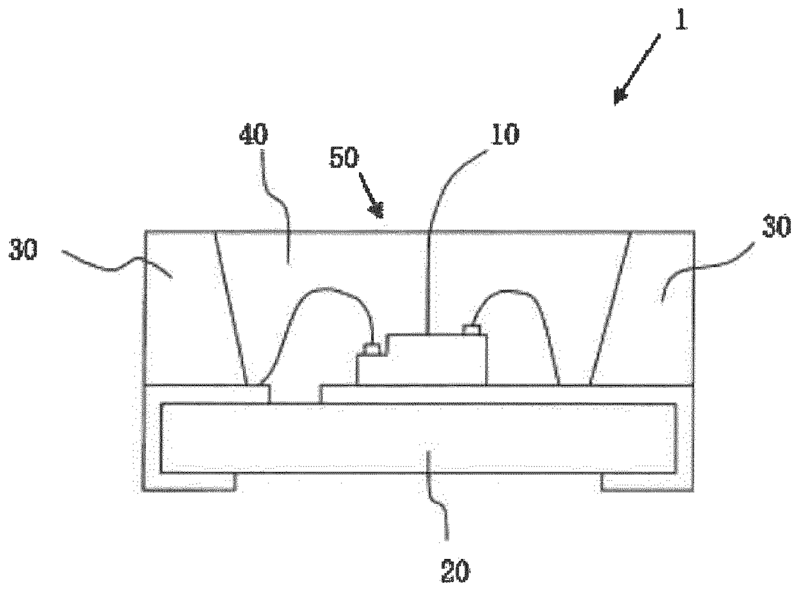


Fig. 1

**Description**

Technical Field

The present invention relates to a polyester composition for an LED reflection plate. In detail, the present invention relates to a polyester composition for an LED reflection plate having a high light reflectance and capable of maintaining a high light reflectance even after being exposed to heat or light, an LED reflection plate composed of the composition, and a light-emitting device including the reflection plate.

Background Art

A light-emitting diode (hereinafter also referred to as "LED") has a lot of merits inclusive of low power consumption and a long life as compared with conventional white lamps or fluorescent lamps, and therefore, it has been applied in various fields and used for relatively small-sized electric and electronic products, such as backlights for liquid crystal panels of mobile phone displays, personal computers, liquid crystal television, etc., and so on.

An LED package is, in general, constituted of an LED, a lead frame, a reflection plate serving also as a housing, and a sealing member for sealing a semiconductor light-emitting element, and as the LED reflection plate, use of a polymer material as a material that is a replacement for the conventional ceramics has been tried and developed.

However, in the reflection plates using a polymer material, there are involved problems inclusive of the decrease in the light reflectance by heat in a production process of the LED package and the decrease in the light reflectance to be caused due to a use environment, such as irradiation with ultraviolet rays, etc.

In response to such problems, for example, PTL 1 discloses an LED reflection plate using a polyamide composition having a dicarboxylic acid unit including a 1,4-cyclohexanedicarboxylic acid unit and a diamine unit including an aliphatic diamine unit having 4 to 18 carbon atoms and describes that even after irradiation with LED light over a long period of time, the high reflectance and whiteness are kept.

However, following the price reduction, in LEDs, applications not only as electric and electronic products but also as lighting fixtures and so on are being widened recently. In the case of using LEDs as lighting fixtures and so on, as compared with light reflection plates which have been used for conventional electric and electronic products and so on, higher heat resistance, high reflectance, and suppression of the decrease in the light reflectance due to heat or light, such as ultraviolet rays, etc. are demanded for a production process and a use environment of LED packages. In response to such a demand, use of a polyester having higher heat resistance as a material for the replacement of the polyamide is tried.

For example, PTL 2 discloses a light-emitting diode assembly housing including a poly(1,4-cyclohexanedimethanol terephthalate) containing titanium dioxide and describes that the light-emitting diode assembly housing has a good light reflectance, good resistance to ultraviolet rays, and color stability upon exposure to heat.

However, the issues of the light reflectance and the maintenance of the high light reflectance after being exposed to heat or light in the production process or use environment of the LED package are not sufficient yet, and more improvements are demanded.

Citation List

Patent Literature

PTL 1: WO 2011/027562 A
PTL 2: JP 2009-507990 A

Summary of Invention

Technical Problem

A problem of the present invention is to provide a polyester composition for an LED reflection plate which has a high light reflectance, shows a small decrease of the light reflectance even after being exposed to heat or light, and is capable of maintaining a high light reflectance, an LED reflection plate composed of the composition, and a light-emitting device including the reflection plate.

Solution to Problem

The present inventors made extensive and intensive investigations. As a result, it has been found that when a polyester composition contains a phenolic antioxidant and a phosphorus-based antioxidant having a specified skeleton in a specified ratio, the aforementioned problem can be solved.

Specifically, the present invention is concerned with the following [1] to [11].

[1] A polyester composition for an LED reflection plate, wherein

the polyester composition contains a polyester (A), a titanium oxide (B), a phenolic antioxidant (C), and a phosphorus-based antioxidant (D),
the polyester (A) being a polyester having a structural unit derived from a dicarboxylic acid including 50 mol% or more of terephthalic acid and a structural unit derived from a diol including 50 mol% or more of 1,4-cyclohexanedimethanol;
the phosphorus-based antioxidant (D) containing three or more groups represented by the following formula (1) in a molecule thereof;
the content of the titanium oxide (B) being 20 to 90 parts by mass, and the content of the phenolic antioxidant (C) being 0.10 to 0.80 parts by mass, on the basis of 100 parts by mass of the polyester (A); and
the content of the phosphorus-based antioxidant (D) satisfying the following equation (I):

$$0.20 \leq \text{mass ratio [component (C)/component (D)]} \leq 5.00 \qquad \text{(I)}$$

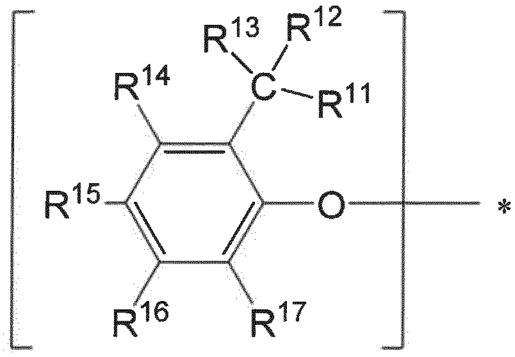

(1)

In the formula (1), $R^{11}$ to $R^{13}$ are each independently an alkyl group having 1 or 2 carbon atoms; $R^{14}$ to $R^{17}$ are each independently a hydrogen atom or an alkyl group having 1 to 10 carbon atoms; and * represents a bonding site with a phosphorus atom.

[2] The polyester composition for an LED reflection plate as set forth in the above [1], wherein the mass ratio of the phenolic antioxidant (C) to the phosphorus-based antioxidant (D) [component (C)/component (D)] satisfies the following equation (I'):

$$0.20 \leq \text{mass ratio [component (C)/component (D)]} \leq 3.00 \qquad \text{(I')}$$

[3] The polyester composition for an LED reflection plate as set forth in the above [1] or [2], further containing 5 to 50 parts by mass of a reinforcing material (E) on the basis of 100 parts by mass of the polyester (A).

[4] The polyester composition for an LED reflection plate as set forth in the above [3], wherein the reinforcing material (E) is a glass fiber.

[5] The polyester composition for an LED reflection plate as set forth in any one of the above [1] to [4], wherein the polyester (A) is a polycyclohexane dimethylene terephthalate having a structural unit derived from a dicarboxylic acid including 75 to 100 mol% of terephthalic acid and a structural unit derived from a diol including 75 to 100 mol% of 1,4-cyclohexanedimethanol.

[6] The polyester composition for an LED reflection plate as set forth in any one of the above [1] to [5], wherein the phosphorus-based antioxidant (D) is at least one selected from the group consisting of phosphites and phosphonites, each having three or more groups represented by the formula (1) in a molecule thereof.

[7] The polyester composition for an LED reflection plate as set forth in any one of the above [1] to [6], wherein the phenolic antioxidant (C) contains at least one group represented by the following formula (2) in a molecule thereof:

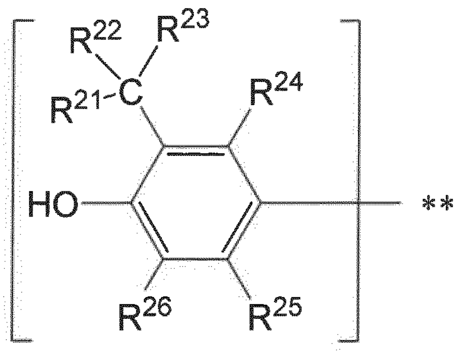
(2)

In the formula (2), $R^{21}$ to $R^{23}$ are each independently an alkyl group having 1 or 2 carbon atoms; $R^{24}$ to $R^{26}$ are each independently a hydrogen atom or an alkyl group having 1 to 10 carbon atoms; and ** represents a bonding site.
[8] The polyester composition for an LED reflection plate as set forth in the above [7], wherein the phenolic antioxidant (C) is at least one selected from the group consisting of phenolic antioxidants of a semi-hindered type or full-hindered type, which have the group represented by the formula (2), wherein $R^{21}$ to $R^{23}$ are all a methyl group, and $R^{26}$ is a methyl group or a t-butyl group.
[9] The polyester composition for an LED reflection plate as set forth in any one of the above [1] to [8], further containing a light stabilizer (F).
[10] An LED reflection plate composed of the polyester composition for an LED reflection plate as set forth in any one of the above [1] to [9].
[11] A light-emitting device, including the LED reflection plate as set forth in the above [10].

Advantageous Effects of Invention

In accordance with the present invention, it is possible to provide a polyester composition for an LED reflection plate which has a high light reflectance, shows a small decrease of the light reflectance even after being exposed to heat or light, and is capable of maintaining a high light reflectance, an LED reflection plate composed of the composition, and a light-emitting device including the reflection plate.

Brief Description of Drawings

[Fig. 1] Fig. 1 is a view schematically illustrating one example of a constitution of the light-emitting device of the present invention.
[Fig. 2] Fig. 2 is a view schematically illustrating one example of a constitution of the light-emitting device of the present invention.
[Fig. 3] Fig. 3 is a view schematically illustrating one example of a constitution of the light-emitting device of the present invention.

Description of Embodiments

[Polyester composition for LED reflection plate]

The polyester composition for an LED reflection plate of the present invention (hereinafter also referred to as "polyester composition") contains a polyester (A), a titanium oxide (B), a phenolic antioxidant (C), and a phosphorus-based antioxidant (D), wherein the polyester (A) is a polyester having a structural unit derived from a dicarboxylic acid including 50 mol% or more of terephthalic acid and a structural unit derived from a diol including 50 mol% or more of 1,4-cyclohexanedimethanol; the phosphorus-based antioxidant (D) contains three or more groups represented by the following formula (1) in a molecule thereof, the content of the titanium oxide (B) is 20 to 90 parts by mass, and the content of the phenolic antioxidant (C) is 0.10 to 0.80 parts by mass, on the basis of 100 parts by mass of the polyester (A); and the content of the phosphorus-based antioxidant (D) satisfies the following equation (I):

$$0.20 \leq \text{mass ratio [component (C)/component (D)]} \leq 5.00 \qquad \text{(I)}$$

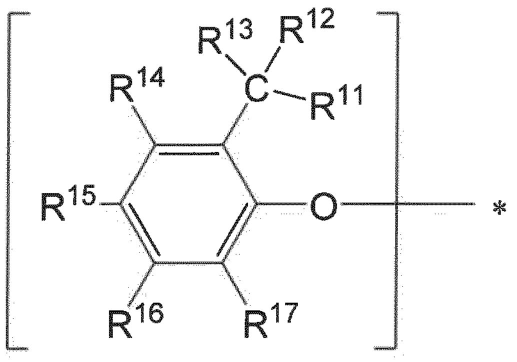

(1)

In the formula (1), $R^{11}$ to $R^{13}$ are each independently an alkyl group having 1 or 2 carbon atoms; $R^{14}$ to $R^{17}$ are each independently a hydrogen atom or an alkyl group having 1 to 10 carbon atoms; and * represents a bonding site with a phosphorus atom.

The polyester composition of the present invention not only has the aforementioned constitution but also contains the phenolic antioxidant and the phosphorus-based antioxidant in a specified ratio, in which the phosphorus-base antioxidant has a specified skeleton. Therefore, there are obtained the effects of the present invention such that the LED reflection plate (hereinafter also referred to merely as a "reflection plate") composed of the foregoing polyester composition has a high light reflectance, shows a small decrease of the light reflectance even after being exposed to heat or light, and is capable of maintaining a high light reflectance.

Though the reasons why such effects are obtained are not elucidated yet, it may be considered that the phenolic antioxidant traps radicals generated by heat or light, and furthermore, the phosphorus-based antioxidant decomposes peroxides generated, whereby these components can cooperatively and effectively inhibit the radical chain reaction to reduce the color change to be caused due to oxidative deterioration.

In particular, the phosphorus-based antioxidant contains three or more groups represented by the formula (1) having an alkyl group at the ortho position adjacent to the bonding site with the oxygen atom bonding to the phosphorus atom, and therefore, it may be considered that the phosphorus-based antioxidant has a higher decomposition capability against peroxides generated by hear or light, and the color change to be caused due to oxidative deterioration can be effectively reduced.

<Polyester (A)>

The polyester composition of the present invention is one containing the polyester (A), and the polyester (A) has a structural unit derived from a dicarboxylic acid including 50 mol% or more of terephthalic acid and a structural unit derived from a diol including 50 mol% or more of 1,4-cyclohexanedimethanol. When the polyester composition of the present invention contains the polyester (A), a reflection plate which has a high light reflectance while having high heat resistance and mechanical strength, shows a small decrease of the light reflectance even after being exposed to heat or light, and is capable of maintaining a high light reflectance can be obtained.

In the polyester (A), a total content of the aforementioned structural unit derived from a dicarboxylic acid and the aforementioned structural unit derived from a diol is preferably 85 mol% or more, and more preferably 90 mol% or more from the viewpoint of improving the heat resistance and the mechanical strength.

The polyester (A) is hereunder described in more detail.

The polyester (A) includes the structural unit derived from a dicarboxylic acid, and the content of terephthalic acid in the dicarboxylic acid is 50 mol% or more. According to this, the heat resistance and the mechanical strength of the obtained reflection plate are improved. The content of terephthalic acid in the dicarboxylic acid is preferably 60 mol% or more, more preferably 75 mol% or more, and even more preferably 90 mol% or more.

The dicarboxylic acid that constitutes the polyester (A) may include other dicarboxylic acid than terephthalic acid within a range of less than 50 mol%. Examples of such other dicarboxylic acid may include aliphatic dicarboxylic acids, such as malonic acid, succinic acid, glutaric acid, adipic acid, pimelic acid, suberic acid, azelaic acid, sebacic acid, etc.; alicyclic dicarboxylic acids, such as 1,3-cyclopentanedicarboxylic acid, 1,4-cyclohexanedicarboxylic acid, etc.; aromatic dicarboxylic acids, such as isophthalic acid, 2,6-naphthalenedicarboxylic acid, 2,7-naphthalenedicarboxylic acid, 1,4-naphthalenedicarboxylic acid, 1,4-phenylenedioxydiacetic acid, 1,3-phenylenedioxydiacetic acid, diphenic acid,

diphenylmethane-4,4'-dicarboxylic acid, diphenylsulfone-4,4'-dicarboxylic acid, 4,4'-biphenyldicarboxylic acid, etc.; and the like. One or more of these other dicarboxylic acids can be included. As such other dicarboxylic acid, isophthalic acid is suitable. The content of such other dicarboxylic acid in the dicarboxylic acid is preferably 40 mol% or less, more preferably 25 mol% or less, and even more preferably 10 mol% or less.

Furthermore, the polyester (A) may also include a structural unit derived from a polyvalent carboxylic acid, such as trimellitic acid, trimesic acid, pyromellitic acid, etc., within a melt-moldable range.

The polyester (A) includes the structural unit derived from a diol, and the content of 1,4-cyclohexanedimethanol in the diol is 50 mol% or more. According to this, the obtained reflection plate is improved in the moldability and the heat resistance, has a high light reflectance, shows a small decrease of the light reflectance even after being exposed to heat or light, and is capable of maintaining a high light reflectance. The content of 1,4-cyclohexanedimethanol in the diol is preferably 60 mol% or more, more preferably 75 mol% or more, and even more preferably 90 mol% or more, and it is preferably 100 mol% or less.

From the viewpoint of heat resistance, it is preferred that a trans-isomer ratio of 1,4-cyclohexanedimethanol is high. The trans-isomer ratio is preferably 50 to 100% by mass, and more preferably 60 to 100% by mass.

The diol that constitutes the polyester (A) may include other diol than 1,4-cyclohexanedimethanol within a range of less than 50 mol%. Examples of such other diol may include aliphatic diols, such as ethylene glycol, 1,2-propanediol, 1,3-propanediol, 1,2-butanediol, 1,3-butanediol, 1,4-butanediol, 2,3-butanediol, neopentyl glycol, 1,4-butenediol, 1,5-pentanediol, 1,6-hexanediol, 1,8-octanediol, 1,9-nonanediol, 1,10-decanediol, 1,12-dodecanediol, etc.; alicyclic diols other than 1,4-cyclohexanedimethanol, such as 1,4-cyclohexanediol, hydrogenated bisphenol A (2,2-bis(4-hydroxycyclohexyl)propane), and their adducts of an alkylene oxide having 2 or more and 4 or less carbon atoms (average addition molar number: 2 or more and 12 or less), etc.; aromatic diols, such as hydroquinone, bis(4-hydroxyphenyl)methane, 2,2-bis(4-hydroxyphenyl)propane, 1,5-dihydroxynaphthalene, etc.; and the like. One or more of these other diols can be included. The content of such other diol in the diol is preferably 40 mol% or less, more preferably 25 mol% or less, and even more preferably 10 mol% or less.

Furthermore, the polyester (A) may also include a structural unit derived from a trihydric or higher hydric alcohol, such as trimethylolpropane, glycerol, pentaerythritol, etc., within a melt-moldable range.

The polyester (A) is preferably a polycyclohexanedimethylene terephthalate having a structural unit derived from a dicarboxylic acid including 75 to 100 mol% of terephthalic acid and a structural unit derived from a diol including 75 to 100 mol% of 1,4-cyclohexanedimethanol. According to this, a reflection plate which has a high light reflectance while having high heat resistance and mechanical strength, shows a small decrease of the light reflectance even after being exposed to heat or light, and is capable of maintaining a high light reflectance can be obtained.

The polyester (A) to be used in the present invention can be produced by adopting any method which is known as a method for producing a polyester. For example, the polyester (A) can be produced through polycondensation reaction of the dicarboxylic acid component and the diol component upon addition of a catalyst, such as a titanium compound, a phosphorus compound, etc., a molecular weight modifier, and so on, if required.

A molar ratio of the dicarboxylic acid component and the diol component (dicarboxylic acid component/diol component) to be applied to the polycondensation reaction is preferably 0.80 to 0.99, more preferably 0.83 to 0.97, and even more preferably 0.85 to 0.98 from the viewpoint of improving the moldability and the mechanical strength and the viewpoint of improving the light reflectance.

A weigh average molecular weight (Mw) of the polyester (A) to be used in the present invention is preferably 3,000 to 12,000, more preferably 4,000 to 10,000, and even more preferably 4,000 to 9,000. When the weight average molecular weight is 3,000 or more, a toughness effect to be brought due to the polyester (A) is sufficiently exhibited, whereas when it is 12,000 or less, good moldability can be obtained without lowering fluidity. The weight average molecular weight can be determined by the means of gel permeation chromatography (GPC) as described later and is a calculated value expressed in terms of standard polymethyl methacrylate.

<Titanium oxide (B)>

The polyester composition of the present invention contains the titanium oxide (B).

The titanium oxide (B) is one imparting light reflectivity to the obtained reflection plate. When the titanium oxide is included, the reflection plate is improved in heat conductivity and heat resistance, shows a small decrease of the light reflectance even after being exposed to heat or light, and is capable of maintaining a high reflectance.

Examples of the titanium oxide (B) include titanium oxide (TiO), titanium trioxide ($Ti_2O_3$), titanium dioxide ($TiO_2$), and the like. All of them may be used, but titanium dioxide is preferred. As the titanium dioxide, one having a crystal structure of a rutile type or an anatase type is preferred, and one having a crystal structure of a rutile type is more preferred.

From the viewpoint of improving the light reflectance, an average particle diameter of the titanium oxide (B) is preferably 0.10 to 0.50 μm, more preferably 0.15 to 0.40 μm, and even more preferably 0.20 to 0.30 μm. The average particle diameter of the titanium oxide (B) can be determined by an image analysis using an electron microscope method.

Specifically, major-axis diameters and minor-axis diameters of 1,000 or more titanium oxide particles photographed using a transmission electron microscope are measured, and an average value thereof is taken as the average particle diameter.

Though the shape of the titanium oxide (B) is not particularly limited, its aggregation shape is preferably irregular. In the case of using the irregular titanium oxide (B), a dimensional change rate and anisotropy of a dimensional change rate of the obtained reflection plate are small, and debonding from a sealing member at the time of production of an LED package can be inhibited.

From the viewpoint of enhancing the dispersibility in the polyester composition, the titanium oxide (B) having been subjected to a surface treatment may be used. Examples of a surface treating agent include metal oxides, such as silica, alumina, zirconia, tin oxide, antimony oxide, zinc oxide, etc.; organosilicon compounds, such as a silane coupling agent, a silicone, etc.; organotitanium compounds, such as a titanium coupling agent, etc.; organic materials, such as an organic acid, a polyol, etc.; and the like.

<Phenolic antioxidant (C)>

The polyester composition of the present invention contains the phenolic antioxidant (C) (hereinafter also referred to as "component (C)").

When the phenolic antioxidant (C) is contained, the phenolic antioxidant traps radicals generated by heat or light, and the decrease in the light reflectance of the obtained reflection plate can be suppressed.

From the viewpoints of improving the light reflectance and suppressing the decrease in the light reflectance, the phenolic antioxidant (C) is preferably a phenolic antioxidant containing at least one group represented by the following formula (2) in a molecule thereof. As shown in the following formula (2), in view of the fact that the alkyl group is present at the ortho group relative to the hydroxy group, more stable phenoxy radicals are formed, and a higher trapping capability of radicals generated by heat or light are revealed.

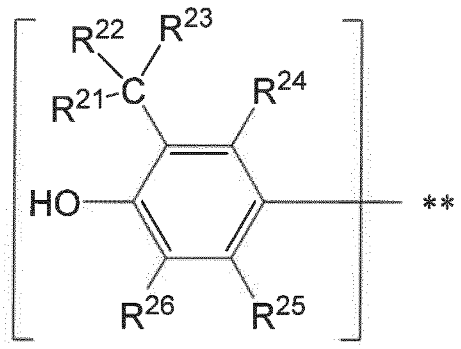

(2)

In the formula (2), $R^{21}$ to $R^{23}$ are each independently an alkyl group having 1 or 2 carbon atoms; $R^{24}$ to $R^{26}$ are each independently a hydrogen atom or an alkyl group having 1 to 10 carbon atoms; and ** represents a bonding site.

In the formula (2), from the viewpoint of suppressing the decrease in the light reflectance, $R^{21}$ to $R^{23}$ are each preferably a methyl group, namely, the group represented by $-C(R^{21})(R^{22})(R^{23})$ is preferably a t-butyl group.

In the formula (2), from the viewpoint of the stability of phenoxy radicals generated after trapping radicals generated by heat or light, $R^{24}$ and $R^{25}$ are each preferably a hydrogen atom or an alkyl group having 1 to 2 carbon atoms, and more preferably a hydrogen atom.

In the formula (2), from the viewpoint of suppressing the decrease in the light reflectance, $R^{26}$ is preferably an alkyl group having 1 to 7 carbon atoms, more preferably an alkyl group having 1 to 4 carbon atoms, and even more preferably a methyl group or a t-butyl group.

From the viewpoints of improving the light reflectance and suppressing the decrease in the light reflectance, the phenolic antioxidant having a group represented by the formula (2) is preferably at least one selected from the group consisting of phenolic antioxidants of a semi-hindered type or full-hindered type, wherein all of $R^{21}$ to $R^{23}$ are a methyl group, and $R^{26}$ is a methyl group or a t-butyl group, and specifically, a phenolic antioxidant represented by the following formula (3), wherein a t-butyl group is present at the ortho position relative to the phenolic hydroxyl group, is more preferred.

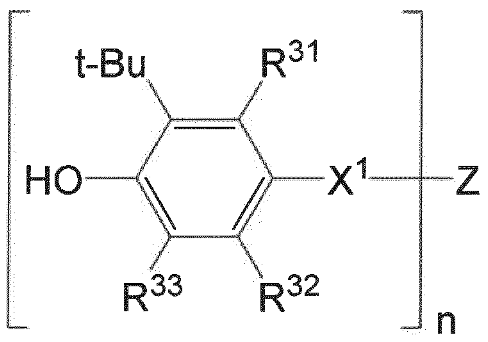

(3)

In the formula (3), $R^{31}$ and $R^{32}$ each independently represent a hydrogen atom or a methyl group; $R^{33}$ represents a methyl group or a t-butyl group; $X^1$ represents a divalent organic group having 1 to 20 carbon atoms; Z represents a monovalent to tetravalent organic group; and n is an integer of 1 to 4.

In the formula (3), from the viewpoint of the stability of phenoxy radicals generated after trapping radicals generated by heat or light, $R^{31}$ and $R^{32}$ are each preferably a hydrogen atom, and from the viewpoints of improving the light reflectance and suppressing the decrease in the light reflectance, $X^1$ is preferably a divalent organic group represented by the following formula (4).

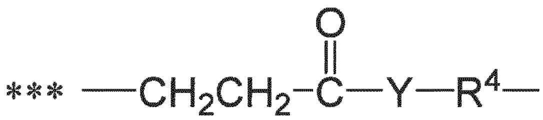

(4)

In the formula (4), $R^4$ represents a single bond or an alkylene group having 1 to 17 carbon atoms; Y represents either an oxygen atom or a group represented by -NH-; and *** represents a bonding site with a hydroxyphenyl group of the formula (3).

In the phenolic antioxidant represented by the formula (3), in the case where n is 1, the phenolic antioxidant is a monofunctional phenolic antioxidant, wherein Z is a monovalent organic group, and a t-butyl group is present at the ortho position relative to the phenolic hydroxyl group (such a phenolic antioxidant will be hereinafter also referred to as "monofunctional phenolic antioxidant").

In the monofunctional phenolic antioxidant to be used in the present invention, from the viewpoints of improving the light reflectance and suppressing the decrease in the light reflectance, Y of the formula (4) is preferably an oxygen atom, and $R^4$ is preferably a single bond. Z of the formula (3) is preferably an alkyl group having 5 to 25 carbon atoms, more preferably an alkyl group having 10 to 22 carbon atoms, even more preferably an alkyl group having 15 to 20 carbon atoms, further even more preferably an alkyl group having 18 carbon atoms, and still further even more preferably a n-octadecyl group.

Examples of the monofunctional phenolic antioxidant include n-octadecyl-3-(3,5-di-t-butyl-4-hydroxyphenyl)propionate and the like. Examples of commercially available products thereof include "Adekastab AO-50" (a trade name, manufactured by Adeka Corporation) and "IRGANOX 1076" (a trade name, manufactured by BASF Japan Ltd.).

In the phenolic antioxidant represented by the formula (3), in the case where n is 2, the phenolic antioxidant is a bifunctional phenolic antioxidant, wherein Z is a divalent organic group, and a t-butyl group is present at the ortho position relative to the phenolic hydroxyl group (such a phenolic antioxidant will be hereinafter also referred to as "bifunctional phenolic antioxidant").

In the bifunctional phenolic antioxidant to be used in the present invention, $R^4$ of the formula (4) is preferably a single bond.

In the case where Y of the formula (4) is a group represented by -NH-, from the viewpoints of improving the light reflectance and suppressing the decrease in the light reflectance, Z of the formula (3) is preferably a straight-chain or branched-chain alkylene group having 1 to 10 carbon atoms, more preferably a straight-chain or branched-chain alkylene group having 4 to 8 carbon atoms, even more preferably an alkylene group having 6 carbon atoms, and further even more preferably a n-hexylene group.

In the case where Y of the formula (4) is an oxygen atom, from the viewpoints of improving the light reflectance and suppressing the decrease in the light reflectance, Z of the formula (3) is preferably at least one selected from the group consisting of an alkylene group having 1 to 10 carbon atoms, an ether group represented by $-X^2-O-X^2-$, a thioether group represented by $-X^2-S-X^2-$, and a divalent organic group having a spiro skeleton derived from pentaerythritol, as represented by the following formula (5); more preferably at least one selected from the group consisting of a thioether group represented by $-X^2-S-X^2-$ and a divalent organic group having a spiro skeleton derived from pentaerythritol, as

represented by the following formula (5); and even more preferably a divalent organic group having a spiro skeleton derived from pentaerythritol, as represented by the following formula (5). $X^2$ in the aforementioned ether group, the aforementioned thioether group, and the divalent organic group represented by the following formula (5) represents a straight-chain or branched-chain alkylene group having 1 to 10 carbon atoms.

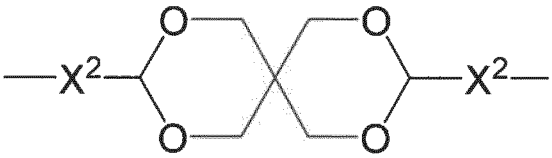
(5)

In the formula (5), $X^2$ represents a straight-chain or branched-chain alkylene group having 1 to 10 carbon atoms.

$X^2$ of the formula (5) is preferably a straight-chain or branched-chain alkylene group having 1 to 7 carbon atoms, more preferably a straight-chain or branched-chain alkylene group having 2 to 4 carbon atoms, and even more preferably a branched-chain butylene group having 4 carbon atoms, and namely, the divalent organic group represented by the formula (5) is preferably one represented by the following formula (5').

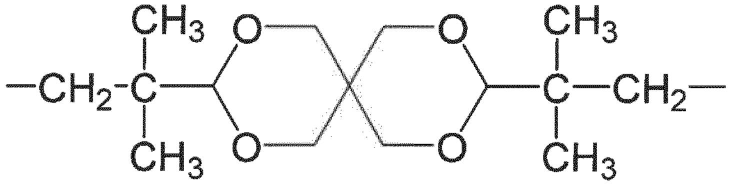
(5')

Examples of the bifunctional phenolic antioxidant includes 2,2-thio-diethylenebis[(3-(3,5-di-t-butyl-4-hydroxyphenyl)propionate], N,N'-hexamethylenebis[(3-(3,5-di-t-butyl-4-hydroxyphenyl)propionamide], triethylene glycol bis[(3-t-butyl-4-hydroxy-5-methylphenyl)propionate], hexamethylenebis[(3-(3,5-di-t-butyl-4-hydroxyphenyl)propionate], 3,9-bis[2-[3-(3-t-butyl-4-hydroxy-5-methylphenyl)propionyloxy]-1,1-dimethylethyl ]-2,4,8,10-tetraoxaspiro[5.5]undecane, and the like. Examples of commercially available products thereof include "IRGANOX 1035", "IRGANOX 1098", "IRGANOX 245", and "IRGANOX 259" (trade names, manufactured by BASF Japan Ltd.), "Adekastab AO-80" (a trade name, manufactured by Adeka Corporation), and "Sumilizer GA-80" (a trade name, manufactured by Sumitomo Chemical Co., Ltd.).

In the phenolic antioxidant represented by the formula (3), in the case where n is 3, the phenolic antioxidant is a trifunctional phenolic antioxidant, wherein Z is a trivalent organic group, and a t-butyl group is present at the ortho position relative to the phenolic hydroxyl group (such a phenolic antioxidant will be hereinafter also referred to as "trifunctional phenolic antioxidant").

Examples of the trifunctional phenolic antioxidant include tris(3,5-di-t-butyl-4-hydroxybenzyl)isocyanurate, 1,3,5-trimethyl-2,4,6-tris(3,5-di-t-butyl-4-hydroxybenzyl)benzene, and the like. Examples of commercially available products thereof include "Adekastab AO-20" (a trade name, manufactured by Adeka Corporation), "Adekastab AO-330" (a trade name, manufactured by Adeka Corporation), and the like.

In the phenolic antioxidant represented by the formula (3), in the case where n is 4, the phenolic antioxidant is a tetrafunctional phenolic antioxidant, wherein Z is a tetravalent organic group, and a t-butyl group is present at the ortho position relative to the phenolic hydroxyl group (such a phenolic antioxidant will be hereinafter also referred to as "tetrafunctional phenolic antioxidant").

In the tetrafunctional phenolic antioxidant to be used in the present invention, from the viewpoints of improving the light reflectance and suppressing the decrease in the light reflectance, in the formula (4), Y is preferably an oxygen atom; and $R^4$ is preferably an alkylene group having 1 to 7 carbon atoms, more preferably an alkylene group having 1 to 3 carbon atoms, and even more preferably a methylene group.

From the viewpoints of improving the light reflectance and suppressing the decrease in the light reflectance, Z of the formula (3) is preferably an oxygen atom.

Examples of the tetravalent phenolic antioxidant include pentaerythrityl-tetrakis[3-(3,5-di-t-butyl-4-hydroxyphenyl)propionate] and the like. Examples of commercially available products thereof include "Adekastab AO-60" (a trade name, manufactured by Adeka Corporation), "IRGANOX 1010" (a trade name, manufactured by BASF Japan Ltd.), and the like.

From the viewpoints of improving the light reflectance and suppressing the decrease in the light reflectance, as the phenolic antioxidant (C) to be used in the present invention, at least one selected from the group consisting of n-octadecyl-3-(3,5-di-t-butyl-4-hydroxyphenyl)propionate (IRGANOX 1076), N,N'-hexamethylenebis[(3-(3,5-di-t-butyl-4-hydroxyphenyl)propionamide] (IRGANOX 1098), 2,2-thio-diethylenebis[(3-(3,5-di-t-butyl-4-hydroxyphenyl)propionate] (IRGANOX 1035), 3,9-bis[2-[3-(3-t-butyl-4-hydroxy-5-methylphenyl)propionyloxy]-1,1-dimethylethyl ]-2,4,8,10-tetraoxaspiro[5.5]undecane (Sumilizer GA-80), and pentaerythrityl-tetrakis[3-(3,5-di-t-butyl-4-hydroxyphenyl)propionate] (IRGANOX 1010) is preferred; at least one selected from the group consisting of n-octadecyl-3-(3,5-di-t-butyl-4-hydroxyphenyl)propionate (IRGANOX 1076), 3,9-bis[2-[3-(3-t-butyl-4-hydroxy-5-methylphenyl)propionyloxy]-1,1-dimethylethyl ]-2,4,8,10-tetraoxaspiro[5.5]undecane (Sumilizer GA-80), and pentaerythrityl-tetrakis[3-(3,5-di-t-butyl-4-hydroxyphenyl)propionate] (IRGANOX 1010) is more preferred; and at least one selected from the group consisting of 3,9-bis[2-[3-(3-t-butyl-4-hydroxy-5-methylphenyl)propionyloxy]-1,1-dimethylethyl ]-2,4,8,10-tetraoxaspiro[5.5]undecane (Sumilizer GA-80) and pentaerythrityl-tetrakis[3-(3,5-di-t-butyl-4-hydroxyphenyl)propionate] (IRGANOX 1010) is even more preferred.

These phenolic antioxidants can be used either alone or in combination of two or more thereof.

<Phosphorus-based antioxidant (D)>

The polyester composition of the present invention contains the phosphorus-based antioxidant (D) (hereinafter also referred to as "component (D)"), and the phosphorus-based antioxidant (D) has three or more groups represented by the following formula (1) in a molecule thereof.

When the phosphorus-based antioxidant (D) is contained, the phosphorus-based antioxidant decomposes peroxides generated by heat or light, and when used in combination with the phenol-based antioxidant (C), a reflection plate which has a high light reflectance and shows a small decrease of the light reflectance even after being exposed to heat or light is obtained. As shown in the following formula (1), in view of the fact that the phosphorus-based antioxidant has an alkyl group at the ortho position adjacent to the bonding site with the phosphorus atom, it has a higher decomposition capability against peroxides generated by hear or light.

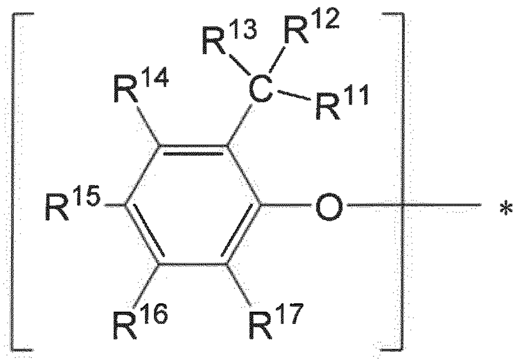 (1)

In the formula (1), $R^{11}$ to $R^{13}$ are each independently an alkyl group having 1 or 2 carbon atoms; $R^{14}$ to $R^{17}$ are each independently a hydrogen atom or an alkyl group having 1 to 10 carbon atoms; and * represents a bonding site with a phosphorus atom.

In the formula (1), from the viewpoint of suppressing the decrease in the light reflectance, $R^{11}$ to $R^{13}$ are each preferably a methyl group, namely, the group represented by $-C(R^{11})(R^{12})(R^{13})$ is preferably a t-butyl group.

In the formula (1), $R^{15}$ is preferably a secondary or tertiary alkyl group having 3 to 7 carbon atoms, more preferably a tertiary alkyl group having 4 or 5 carbon atoms, and even more preferably a t-butyl group.

In the formula (1), from the viewpoints of lowering the steric hindrance and improving the reactivity with peroxides generated by heat or light, $R^{14}$ and $R^{16}$ are each independently preferably a hydrogen atom or an alkyl group having 1 to 2 carbon atoms, and more preferably a hydrogen atom.

In the formula (1), from the viewpoints of lowering the steric hindrance and improving the reactivity with peroxides generated by heat or light, $R^{17}$ is preferably a hydrogen atom or an alkyl group having 1 to 7 carbon atoms, and more preferably a hydrogen atom.

As the phosphorus-based antioxidant (D), from the viewpoint of suppressing the decrease in the light reflectance, at least one selected from the group consisting of phosphites and phosphonites, each having three or more groups represented by the formula (1) in a molecule thereof is preferred; and at least one selected from phosphorus-based antioxidants represented by the following general formulae (6) to (7) is more preferred.

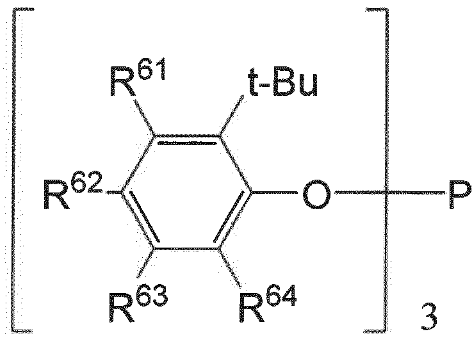

(6)

In the formula (6), $R^{61}$, $R^{63}$, and $R^{64}$ each independently represent a hydrogen atom or a methyl group; and $R^{62}$ represents an alkyl group having 1 to 10 carbon atoms.

In the formula (6), $R^{62}$ is preferably a secondary or tertiary alkyl group having 3 to 7 carbon atoms, more preferably a tertiary alkyl group having 4 or 5 carbon atoms, and even more preferably a t-butyl group.

In the formula (6), from the viewpoints of lowering the steric hindrance and improving the reactivity with peroxides generated by heat or light, $R^{61}$, $R^{63}$, and $R^{64}$ are each preferably a hydrogen atom.

As the phosphorus-based antioxidant represented by the formula (6), tris(2,4-di-t-butylphenyl)phosphite is preferred. Examples of commercially available products thereof include "IRGAFOS 168" (a trade name, manufactured by BASF Japan Ltd.) and the like.

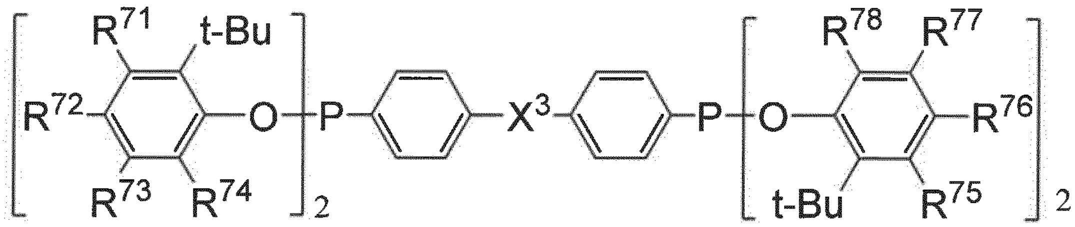

(7)

In the formula (7), $R^{71}$, $R^{73}$, $R^{74}$, $R^{75}$, $R^{77}$, and $R^{78}$ each independently represent a hydrogen atom or a methyl group; $R^{72}$ and $R^{76}$ each independently represent an alkyl group having 1 to 10 carbon atoms; and $X^3$ represent a single bond, -O-, -S-, $-SO_2-$, or a divalent organic group having 1 to 10 carbon atoms.

In the formula (7), $R^{72}$ and $R^{76}$ are each preferably a secondary or tertiary alkyl group having 3 to 7 carbon atoms, more preferably a tertiary alkyl group having 4 or 5 carbon atoms, and even more preferably a t-butyl group.

In the formula (7), $R^{71}$, $R^{73}$, $R^{74}$, $R^{75}$, $R^{77}$, and $R^{78}$ are each preferably a hydrogen atom.

In the formula (7), $X^3$ is preferably a single bond.

Examples of the phosphorus-based antioxidant represented by the formula (7) include tetrakis(2,4-di-t-butylphenyl)-4,4'-biphenylene diphosphonite, tetrakis(2,4-di-t-butyl-5-methylphenyl)-4,4'-biphenylene diphosphonite, and the like. From the viewpoints of improving the light reflectance and suppressing the decrease in the light reflectance, tetrakis(2,4-di-t-butylphenyl)-4,4'-biphenylene diphosphonite is preferred.

Examples of commercially available products thereof include "Hostanox P-EPQ" (a trade name, manufactured by Clariant Japan K.K.), "GSY-P101" (a trade name, manufactured by Sakai Chemical Industry Co., Ltd.), and the like.

These phosphorus-based antioxidants can be used either alone or in combination of two or more thereof.

As the phosphorus-based antioxidant (D), from the viewpoint of suppressing the decrease in the light reflectance, at least one selected from the group consisting of tris(2,4-di-t-butylphenyl)phosphite ("IRGAFOS 168") and tetrakis(2,4-di-t-butylphenyl)-4,4'-biphenylene diphosphonite ("Hostanox P-EPQ") is preferred, and tetrakis(2,4-di-t-butylphenyl)-4,4'-biphenylene diphosphonite ("Hostanox P-EPQ") is more preferred.

As a suitable combination of the phenol-based antioxidant (C) with the phosphorus-based antioxidant (D), from the viewpoints of improving the light reflectance and suppressing the decrease in the light reflectance, a combination of at least one phenolic antioxidant selected from the group consisting of n-octadecyl-3-(3,5-di-t-butyl-4-hydroxyphenyl)propionate (IRGANOX 1076), N,N'-hexamethylenebis[(3-(3,5-di-t-butyl-4-hydroxyphenyl)propionamide] (IRGANOX 1098), 2,2-thio-diethylenebis[(3-(3,5-di-t-butyl-4-hydroxyphenyl)propionate] (IRGANOX 1035), 3,9-bis[2-[3-(3-t-butyl-4-hydroxy-5-methylphenyl)propionyloxy]-1,1-dimethylethyl ]-2,4,8,10-tetraoxaspiro[5.5]undecane (Sumilizer GA-80), and pentaerythrityl-tetrakis[3-(3,5-di-t-butyl-4-hydroxyphenyl)propionate] (IRGANOX 1010) with at least one phosphorus-based antioxidant selected from the group consisting of tris(2,4-di-t-butylphenyl)phosphite (IRGAFOS 168) and tetrakis(2,4-di-t-butylphenyl)-4,4'-biphenylene diphosphonite (Hostanox P-EPQ) is preferred; and at least one selected

from a combination of n-octadecyl-3-(3,5-di-t-butyl-4-hydroxyphenyl)propionate (IRGANOX 1076) with tetrakis(2,4-di-t-butylphenyl)-4,4'-biphenylene diphosphonite (Hostanox P-EPQ), a combination of 3,9-bis[2-[3-(3-t-butyl-4-hydroxy-5-methylphenyl)propionyloxy]-1,1-dimethylethyl ]-2,4,8,10-tetraoxaspiro[5.5]undecane (Sumilizer GA-80) with tetrakis(2,4-di-t-butylphenyl)-4,4'-biphenylene diphosphonite (Hostanox P-EPQ), a combination of pentaerythrityl-tetrakis[3-(3,5-di-t-butyl-4-hydroxyphenyl)propionate] (IRGANOX 1010) with tetrakis(2,4-di-t-butylphenyl)-4,4'-biphenylene diphosphonite (Hostanox P-EPQ), and a combination of N,N'-hexamethylenebis[(3-(3,5-di-t-butyl-4-hydroxyphenyl)propionamide] (IRGANOX 1098) with tris(2,4-di-t-butylphenyl)phosphite (IRGAFOS 168) is more preferred.

<Reinforcing material (E)>

It is preferred that the polyester composition of the present invention further contains a reinforcing material (E). When the reinforcing material (E) is included, the moldability and the mechanical strength of the obtained reflection plate can be improved.

As the reinforcing material (E), there can be used ones having various forms, such as a fibrous form, a tabular form, an acicular form, a powdery form, a cloth form, etc. Specifically, examples thereof include fibrous reinforcing materials, such as a glass fiber, a carbon fiber, an aramid fiber, a liquid crystal polymer (LCP) fiber, a metal fiber, etc.; tabular reinforcing materials, such as mica, talc, etc.; acicular reinforcing materials, such as a potassium titanate whisker, an aluminum borate whisker, a calcium carbonate whisker, a magnesium sulfate whisker, wollastonite, sepiolite, xonotlite, a zinc oxide whisker, etc.; powdery reinforcing materials, such as silica, alumina, barium carbonate, magnesium carbonate, aluminum nitride, boron nitride, potassium titanate, aluminum silicate (e.g., kaolin, clay, pyrophyllite, or bentonite), calcium silicate, magnesium silicate (e.g., attapulgite), aluminum borate, calcium sulfate, barium sulfate, magnesium sulfate, asbestos, glass beads, carbon black, graphite, a carbon nanotube, silicon carbide, sericite, hydrotalcite, molybdenum disulfide, a phenol resin particle, a crosslinked styrene-based resin particle, a crosslinked acrylic resin particle, etc.; cloth-shaped reinforcing materials, such as a glass cloth, etc.; and the like. These reinforcing materials can be used either alone or in combination of two or more thereof.

As the reinforcing materials, from the viewpoint of enhancing the dispersibility in the polyester composition and from the viewpoint of enhancing the adhesion to the polyester (A), one having been subjected to a surface treatment may be used. Examples of a surface treating agent include a silane coupling agent, a titanium coupling agent, a polymer compound, such as an acrylic resin, a urethane resin, an epoxy resin, etc., or other low-molecular compound, and the like.

Among the aforementioned reinforcing materials, the reinforcing material (E) is preferably at least one selected from the group consisting of fibrous reinforcing materials and acicular reinforcing materials from the viewpoint of suppressing the cost and the viewpoint of improving the mechanical strength; and it is more preferably a fibrous reinforcing material, and even more preferably a glass fiber from the viewpoints of suppressing the cost and the viewpoint of improving the mechanical strength. In addition, from the viewpoint of obtaining a reflection plate having high surface smoothness, an acicular reinforcing material is more preferred. In particular, from the viewpoint of holding the whiteness of the reflection plate, at least one selected from the group consisting of a glass fiber, wollastonite, a potassium titanate whisker, a calcium carbonate whisker, and an aluminum borate whisker is preferred; at least one selected from the group consisting of a glass fiber and wollastonite is more preferred; and a glass fiber is even more preferred.

An average fiber length of the glass fiber is preferably 1 to 10 mm, more preferably 1 to 7 mm, and even more preferably 2 to 4 mm. In addition, though a cross-sectional shape of the glass fiber is not particularly limited, from the viewpoints of productivity and mechanical strength, a modified cross-section or a circular cross-section is preferred, and from the viewpoint of suppressing the cost, a circular cross-section is more preferred.

Here, the glass fiber having a modified cross-section refers to a glass fiber having a cross-sectional shape in which in the cross-section perpendicular to the length direction of the fiber, the length of the outer periphery of the cross-section is 1.05 to 1.7 times relative to the length of the outer periphery of the glass fiber cross-section having a true circular cross-section having the same cross-sectional area. As the cross-sectional shape, in particular, a cocoon-like shape narrow in the lengthwise mid-portion of the cross-section and an oval shape or elliptical shape having parts approximately parallel at the symmetric positions to the centroid of the cross-section are preferred.

From the viewpoint of improving the mechanical strength, an average fiber diameter of the glass fiber is preferably 6 to 20 $\mu$m, and more preferably 6 to 15 $\mu$m.

The average fiber length and the average fiber diameter of the glass fiber can be determined by the image analysis using an electron microscope method in the same method as the aforementioned measurement of the average particle diameter of the titanium oxide (B).

<Light stabilizer (F)>

From the viewpoints of preventing the discoloration of the obtained reflection plate and suppressing the decrease in the light reflectance, it is preferred that the polyester composition of the present invention further contains a light

stabilizer (F).

Examples of the light stabilizer (F) include compounds having an ultraviolet absorbing effect, such as benzophenone-based compounds, salicylate-based compounds, benzotriazole-based compounds, acrylonitrile-based compounds, other conjugated compounds, etc.; compounds having a radical trapping capability, such as hindered amine-based compounds, etc.; and the like. In particular, from the viewpoints of high affinity with the polyester (A) and an improvement in the heat resistance, the light stabilizer (F) is preferably a compound having an amide bond in a molecule thereof. In addition, from the viewpoint of obtaining a higher stabilizing effect, combined use of a compound having an ultraviolet absorbing effect with a compound having a radical trapping capability is preferred. These light stabilizers can be used either alone or in combination of two or more thereof.

[Other components]

The polyester composition of the present invention can also be further blended with other components, such as nigrosine or other organic or inorganic colorant; an antistatic agent; a crystal nucleating agent; a plasticizer; a wax, e.g., a polyolefin wax, a higher fatty acid ester, etc.; a release agent, e.g., a silicone oil, etc.; a lubricant; etc.

In the case of blending other components in the polyester composition of the present invention, the content of each of the other components is preferably 5 parts by mass or less on the basis of 100 parts by mass of the polyester (A).

[Content of each component in polyester composition]

The content of the polyester (A) to be used in the present invention in the polyester composition is preferably 40% by mass or more, more preferably 45% by mass or more, and even more preferably 50% by mass or more from the viewpoint of improving the moldability into an LED reflection plate, the heat resistance, and the mechanical strength, and is also preferably 80% by mass or less, more preferably 75% by mass or less, and even more preferably 70% by mass or less from the viewpoints of mechanical physical properties of the obtained reflection plate and obtaining a high reflectance.

The content of the titanium oxide (B) to be used in the present invention is 20 parts by mass or more, preferably 25 parts by mass or more, and even more preferably 30 parts by mass on the basis of 100 parts by mass of the polyester (A) from the viewpoint of obtaining a high light reflectance, and is also 90 parts by mass or less, preferably 85 parts by mass or less, and more preferably 80 parts by mass or less on the basis of 100 parts by mass of the polyester (A) from the viewpoint of improving the moldability into an LED reflection plate, the heat resistance, and the mechanical strength.

The content of the phenolic antioxidant (C) to be used in the present invention is 0.10 parts by mass or more, preferably 0.13 parts by mass or more, and more preferably 0.15 parts by mass or more on the basis of 100 parts by mass of the polyester (A) from the viewpoint of obtaining a high light reflectance and the viewpoint of suppressing the decrease in the light reflectance, and is also 0.80 parts by mass or less, preferably 0.75 parts by mass or less, more preferably 0.60 parts by mass or less, even more preferably 0.50 parts by mass or less, and further even more preferably 0.30 parts by mass or less on the basis of 100 parts by mass of the polyester (A) from the viewpoint of suppressing the decrease in the light reflectance following inferiority, such as gas burning to be caused due to gases generated at the time of molding, etc.

In the present invention, a mass ratio of the phenolic antioxidant (C) to the phosphorus-based antioxidant (D) [component (C)/component (D)] satisfies the following equation (I):

$$0.20 \leq \text{mass ratio [component (C)/component (D)]} \leq 5.00 \qquad \text{(I)}$$

From the viewpoint of obtaining a high light reflectance and the viewpoint of suppressing the decrease in the light reflectance, the mass ratio [component (C)/component (D)] is 0.20 or more, preferably 0.30 or more, more preferably 0.50 or more, and even more preferably 0.70 or more, and from the viewpoint of suppressing the decrease in the light reflectance following inferiority, such as gas burning to be caused due to gases generated at the time of molding, etc., the mass ratio [component (C)/component (D)] is 5.00 or less, preferably 3.00 or less, more preferably 2.00 or less, even more preferably 1.50 or less, and further even more preferably 1.00 or less.

From the viewpoint of obtaining a high light reflectance, the viewpoint of suppressing the decrease in the light reflectance, and the viewpoint of suppressing the decrease in the light reflectance following inferiority, such as gas burning to be caused due to gases generated at the time of molding, etc., it is preferred that the mass ratio of the phenolic antioxidant (C) to the phosphorus-based antioxidant (D) [component (C)/component (D)] satisfies the following equation (I'):

$$0.20 \leq \text{mass ratio [component (C)/component (D)]} \leq 3.00 \qquad (I')$$

However, a total content of the phenolic antioxidant (C) and the phosphorus-based antioxidant (D) in the polyester composition of the present invention is preferably 1.5 parts by mass or less, and more preferably 1.0 part by mass or less on the basis of 100 parts by mass of the polyester (A). When the foregoing total content is 1.5 parts by mass or less, the amount of gases generated at the time of molding the polyester composition is small, and therefore, there can be avoided deficiencies, such as the occurrence of gas burning to be caused due to gas residue generated on the molded article surface and the discoloration during the heating time and the light treatment time.

The content of the reinforcing material (E) to be used in the present invention is preferably 5 parts by mass or more, more preferably 10 parts by mass or more, and even more preferably 15 parts by mass or more on the basis of 100 parts by mass of the polyester (A) from the viewpoint of improving the heat resistance and the mechanical strength, and is also preferably 50 parts by mass or less, and more preferably 40 parts by mass or less on the basis of 100 parts by mass of the polyester (A) from the viewpoint of obtaining a high light reflectance and the viewpoint of suppressing the decrease in the light reflectance.

The content of the light stabilizer (F) to be used in the present invention is preferably 0.10 parts by mass or more, and more preferably 0.15 parts by mass or more on the basis of 100 parts by mass of the polyester (A) from the viewpoints of preventing the discoloration of the obtained reflection plate and suppressing the decrease in the light reflectance and in particular, from the viewpoint of suppressing the decrease in the light reflectance after being exposed to light, and is also preferably 2.0 parts by mass or less, more preferably 1.2 parts by mass or less, even more preferably 0.8 parts by mass or less, and further even more preferably 0.5 parts by mass or less on the basis of 100 parts by mass of the polyester (A) from the viewpoint of suppressing the cost. In addition, from the viewpoint of suppressing the decrease in the light reflectance after being exposed to heat, the content of the light stabilizer (F) is still further even more preferably 0.3 parts by mass or less on the basis of 100 parts by mass of the polyester (A).

The polyester composition of the present invention can be prepared by mixing the aforementioned respective components by a known method. Examples of the method include a method in which each of the components is added during the polycondensation reaction of the polyester (A); a method in which the polyester (A) and the other components are dry blended; a method in which the respective components are melt kneaded by using an extruder; and the like. Among these, the method in which the respective components are melt kneaded by using an extruder is preferred because of easiness in the operation, the capability of obtaining a homogeneous composition, and the like. The extruder to be used on this occasion is preferably a twin-screw type one, and a melt kneading temperature is preferably a temperature within a range of from a temperature higher by 5°C than the melting point of the polyester (A) to 350°C or lower.

[LED reflection plate]

The LED reflection plate of the present invention is obtained by molding the aforementioned polyester composition of the present invention. As for the molding method, the reflection plate can be obtained by a molding method usually used for thermoplastic resin compositions, such as injection molding, extrusion molding, press molding, blow molding, calendar molding, cast molding, etc. In addition, the reflection plate can also be obtained by a molding method through combination of the aforementioned molding methods. In particular, injection molding is preferred from the viewpoints of easiness in molding, mass production, and suppression of the cost. In addition, the LED reflection plate of the present invention can also be obtained by subjecting the aforementioned polyester composition and other polymers to composite molding. Furthermore, the aforementioned polyester composition can also be composited with a molding body made of a metal, a fabric, or the like.

The LED reflection plate of the present invention is characterized in that the reflectance of light of a wavelength of 460 nm by a spectrophotometer is small in its decrease even after being exposed to heat or light and can be held at high levels. For example, in the case where the content of the titanium oxide (B) is 33 parts by mass on the basis of 100 parts by mass of the polyester (A), the decrease in the reflectance from the initial reflectance after short-term heating at 170°C for 5 hours is preferably 3.5% or less, more preferably 3.0% or less, even more preferably 2.5% or less, further even more preferably 2.0% or less, and still further even more preferably 1.5% or less. According to this, the decrease in the light reflectance after being exposed to heat in the production process of the LED package can be suppressed. In addition, the decrease in the reflectance from the initial reflectance after long-term heating at 120°C for 600 hours is preferably 6.0% or less, more preferably 5.5% or less, even more preferably 5.0% or less, further even more preferably 4.5% or less, still further even more preferably 4.0% or less, and still further even more preferably 3.5% or less. According to this, the decrease in the light reflectance even in an environment of using the reflection plate for a long term.

For example, in the case where the content of the titanium oxide (B) is 33 parts by mass on the basis of 100 parts by mass of the polyester (A), the initial reflectance of light of a wavelength of 460 nm of the LED reflection plate

of the present invention by a spectrophotometer is preferably 93% or more, more preferably 94% or more, and even more preferably 94.5% or more.

The measurement of each of the aforementioned reflectances is performed by a method described in Examples.

Furthermore, for example, in the case where the content of the titanium oxide (B) is 33 parts by mass on the basis of 100 parts by mass of the polyester (A), the reflectance of light of a wavelength of 460 nm of the LED reflection plate of the present invention after the light irradiation at 120°C for 1,500 hours as measured by a spectrophotometer is preferably 86.0% or more, more preferably 86.5% or more, and even more preferably 87.0% or more.

The aforementioned light irradiation is one using light of a metal halide lamp through a filter of allowing light of 295 nm to 780 nm to pass therethrough in air at a position where an illuminance in wavelengths of 300 to 400 nm is 10 $mW/cm^2$ by a method described in Examples.

The measurement of the aforementioned reflectance is performed by a method described in Examples.

The LED reflection plate of the present invention is small in the decrease of the light reflectance even after being exposed to heat or light particularly in the production process or use environment of the LED package and maintains a high light reflectance (reflectance to light in the vicinity of a wavelength of 460 nm). Accordingly, the LED reflection plate of the present invention can be suitably used as reflection plates for LED to be used, for example, for backlight sources, lighting fixtures, various types of lamps for cars, and so on. A light-emitting device including the LED reflection plate of the present invention has a long life.

[Light-emitting device]

The light-emitting device of the present invention includes the aforementioned LED reflection plate of the present invention. Examples of the light-emitting device of the present invention include backlight sources, light sources for illumination, light sources for various types of lamps for cars, and the like.

Fig. 1 illustrates one example of a typical constitution of the light-emitting device of the present invention. Fig. 1 is a view schematically illustrating a light-emitting device (LED device) 1 of an SMD (surface mounted device) type. In the light-emitting device 1, a semiconductor light-emitting element 10 is disposed in a package-form section 50 formed of a substrate 20 and a reflector (housing) 30, and a sealing member 40 (light-transmissive resin) is filled in the package-form section 50.

Each of the elements of the light-emitting device of the present invention is hereunder described. It should be construed that the light-emitting device of the present invention is not limited by the following elements.

<Semiconductor light-emitting element>

As the semiconductor light-emitting element 10, one having a light-emission peak wavelength in the wavelength region of 500 nm or shorter is suitably usable. The semiconductor light-emitting element which is usable is not limited to one having a single light-emission peak, and one having a plurality of light-emission peaks is also usable. Here, in the case of having a plurality of light-emission peaks, the semiconductor light-emitting element may have one or more light-emission peaks in a wavelength region longer than 500 nm. In addition, there can further be used a semiconductor light-emitting element having a light-emission peak in the long wavelength region of visible light (501 nm to 780 nm).

The constitution of the semiconductor light-emitting element 10 is not particularly limited so far as it has the aforementioned wavelength properties. There can be used one having a semiconductor of, for example, GaAlN, ZnS, ZnSe, SiC, GaP, GaAlAs, AlN, InN, AlInGaP, InGaN, GaN, AlInGaN, etc., formed as a light-emitting layer.

In addition, the light-emitting layer may be one containing an optional dopant.

As the semiconductor light-emitting element 10, a plurality of semiconductor light-emitting elements can be properly used. The semiconductor light-emitting element may be composed of, for example, two light-emitting elements capable of emitting green light, one light-emitting element capable of emitting blue light and one light-emitting element capable of emitting red light.

Though a connection method of the semiconductor light-emitting element 10 to the substrate 20 is not particularly limited, a conductive epoxy or silicone adhesive can be used. Furthermore, in order to efficiently conduct heat generated from the semiconductor light-emitting element to the substrate, a low-melting point metal can be used. Examples thereof may include Sn/Ag/Cu (melting point: 220°C), Sn/Au (melting point: 282°C), and the like.

<Package>

A package is a member on which the semiconductor light-emitting element 10 is mounted, and a part or the whole thereof is formed of the aforementioned LED reflection plate of the present invention. The package may be composed of a single member, or may be constituted of a combination of a plurality of members.

The package preferably has a recess portion (cup-shaped portion). One example of the package is a combination

of a reflector (housing) and a substrate, and for example, in Fig. 1, a package is constituted by adhering the reflector (housing) 30 of a desired shape on the substrate 20 such that a recess portion (cup-shaped portion) is formed. The substrate 20 and the reflector 30 are formed of the LED reflection plates of the present invention molded from the aforementioned polyester composition. Only one of the substrate 20 and the reflector 30 may also be formed of the LED reflection plate of the present invention. In this way, in the case of using a plurality of the LED reflection plates of the present invention, there may be used a combination of the LED reflection plates having different properties from each other obtained by forming the LED reflection plates by varying the composition of the polyester composition. Another example is a constitution in which the aforementioned polyester composition is molded so as to form a recess portion (cup-shaped portion) on one surface side thereof, thereby forming the package as one LED reflection plate. As still another example, there can also be used a package composed only of a tabular LED reflection plate.

The recess portion (cup-shaped portion) formed in the package refers to a portion composed of a space having a shape which has the bottom part and the side surface part, and whose area of the cross-section in the direction perpendicular to the optical axis continuously or stepwise increases from the bottom part toward the side on which light is emitted from the light-emitting device. The shapes of the bottom part and the side surface part are not particularly limited so far as such a condition is satisfied.

<Sealing member>

The sealing member 40 is a member formed so as to cover the semiconductor light-emitting element 10 and is provided for the purpose of protecting the semiconductor light-emitting element 10 mainly from the outside environment.

For the sealing member 40, a transparent thermosetting resin can be used for the purpose of protecting the semiconductor light-emitting element 10 and wirings. Examples of the transparent thermosetting resin may include thermosetting resins including an epoxy or a silicone. With respect to the silicone, any of resin types, rubber types, and gel types can be used according to required properties of the package. In addition, in order to enhance the adhesion of the reflector 30 to the sealing member 40, the reflector 30 can be treated with a rare gas plasma of argon gas or the like.

The sealing member 40 can also be provided such that a plurality of layers composed of different materials are laminated and formed on the semiconductor light-emitting element 10.

The sealing member 40 can also contain a fluorescent substance. Use of the fluorescent substance enables a part of light from the semiconductor light-emitting element 10 to be converted to light having a different wavelength, and can thus change or adjust the emission color of the light-emitting device.

Any fluorescent substance can be used so far as it can be excited by light from the semiconductor light-emitting element 10. There is preferably used at least one selected from the group consisting of, for example, nitride fluorescent substances, oxynitride-based fluorescent substances, and sialon-based fluorescent substances activated mainly with a lanthanoid series element, such as Eu, Ce, etc.; alkaline earth metal aluminate fluorescent substances, alkaline earth silicates, alkaline earth sulfides, alkaline earth thiogallates, alkaline earth silicon nitrides, and germinates activated mainly with a lanthanoid series element, such as Eu, etc., or a transition metal element, such as Mn, etc.; rare earth aluminates and rare earth silicates activated mainly with a lanthanoid series element, such as Ce, etc., organic compounds and organic complexes activated mainly with a lanthanoid series element, such as Eu, etc.; and the like.

The sealing member 40 can also include a combination of a plurality of fluorescent substances. In this case, there can also be used a combination of a fluorescent substance emitting light by being excited with light from the semiconductor light-emitting element 10 and another fluorescent substance emitting light by being excited with light from the former fluorescent substance.

The sealing member 40 may contain a light diffusion material, such as titanium dioxide, zinc oxide, etc., to promote the diffusion of light within the sealing member 40, thereby enabling light-emission unevenness to be reduced.

The light-emitting device 1 of Fig. 1 is, for example, produced in the following manner. First of all, the reflector 30 that is the LED reflection plate of the present invention is disposed on the substrate 20 that is the LED reflection plate of the present invention. Subsequently, the semiconductor light-emitting element 10 is mounted, and electrodes of the semiconductor light-emitting element 10 and a wiring pattern on the substrate 20 are connected through leads. Subsequently, a liquid silicone sealant composed of a main agent and a curing agent is prepared and then potted in a cup-shaped portion. The resultant is heated to about 150°C in this state, thereby thermally curing the silicone sealant. Thereafter, the resultant is allowed to dissipate heat in air.

Fig. 2 illustrates a schematic view of a light-emitting device 2 of the present invention having another constitution. In Fig. 2, the same elements as in the light-emitting device 1 are given the same reference signs. In the light-emitting device 2, a lead frame 80 is used in place of the substrate, and the semiconductor light-emitting element 10 is mounted on the lead frame 80. The other constitution is the same as in the light-emitting device 1.

Fig. 3 illustrates a schematic view of a light-emitting device 3 of the present invention having still another constitution. In Fig. 3, the same elements as in the light-emitting device 1 are given the same reference signs. In the light-emitting device 3, a substrate 70 that is the LED reflection plate of the present invention is used. The substrate 70

is provided with a desired wiring 71. In addition, no housing (reflector) is used, and as illustrated in the figure, after the semiconductor light-emitting element 10 is mounted, a sealing member 60 can be formed by molding using a desired mold. In addition, the sealing member 60 molded into a desired shape may be previously prepared and then adhered to the substrate 70 so as to cover the semiconductor light-emitting element 10.

In the light of the above, there have been described the light-emitting devices of an SMD type as constitution examples of the present invention, but the present invention can also apply to so-called shell-type light-emitting diodes, which are made by mounting a semiconductor light-emitting element on a lead frame having a cup-shaped portion and covering the semiconductor light-emitting element and a part of the lead frame with a sealing member. In addition, the present invention can also apply to light-emitting devices of a flip chip type, in which a semiconductor light-emitting element is mounted in a so-called flip chip form on a substrate or a lead frame.

## Examples

The present invention is hereunder described in more detail by reference to Examples and Comparative Examples, but it should be construed that the present invention is not limited to the following Examples.

The respective evaluations in the Examples and Comparative Examples were performed in accordance with the methods shown below.

### (Melting point)

With respect to the melting point of the polyester, there was determined, as the melting point (°C), the peak temperature of the melting peak appearing when the temperature was raised under a nitrogen atmosphere from 30°C to 350°C at a rate of 10°C/min by using a differential scanning calorimetric analyzer "DSC 822", manufactured by Mettler Toledo International Inc. In the case where a plurality of melting peaks were appeared, the peak temperature of the melting peak on the highest temperature side was determined as the melting point.

### (Weight average molecular weight)

The weight average molecular weight was measured under the following conditions by means of GPC.

Column: Two of "TSKgel Super HM-N", manufactured by Tosoh Corporation
Eluent: Hexafluoroisopropanol (added with 0.085% by mass of sodium trifluoroacetate)
Flow rate: 0.4 mL/min
Sample: Prepared by dissolving 2.5 mg of the polyester (A) in 5 mL of a hexafluoroisopropanol solution (added with 0.085% by mass of sodium trifluoroacetate)
Column temperature: 40°C
Detector: Ultraviolet detector (measurement wavelength: 254 nm)
Reference material: Polymethyl methacrylate

### (Initial reflectance)

A polyester composition obtained in each of the Examples and Comparative Examples was used and injection molded (mold temperature: 140°C) at a cylinder temperature higher by about 20°C than the melting point of the polyester; a test piece of a size of 1 mm in thickness, 40 mm in width, and 100 mm in length was fabricated; the reflectance (initial reflectance) of light of a wavelength of 460 nm of the test piece was determined by a spectrophotometer (U-4000), manufactured by Hitachi, Ltd. In addition, the initial reflectance was evaluated according to the following evaluation criteria. The results are shown in Tables 1 and 2.

[Evaluation criteria]

A: The initial reflectance is 94% or more.
B: The initial reflectance is 93% or more and less than 94%.
C: The initial reflectance is 92% or more and less than 93%.

(Decrease (1) in reflectance after short-term heating)

A polyester composition obtained in each of the Examples and Comparative Examples was used and injection molded (mold temperature: 140°C) at a cylinder temperature higher by about 20°C than the melting point of the polyester; and a test piece of a size of 1 mm in thickness, 40 mm in width, and 100 mm in length was fabricated. This test piece was subjected to a heat treatment at 170°C in a hot-air dryer for 5 hours. The reflectance (1) of light of a wavelength of 460 nm of the test piece after the heat treatment was determined by a spectrophotometer (U-4000), manufactured by Hitachi, Ltd., and the decrease (1) in reflectance after short-term heating was determined according to the following equation. In addition, the decrease (1) was evaluated according to the following evaluation criteria. The results are shown in Tables 1 and 2.

$$\text{Decrease (1) (\%)} = (\text{Initial reflectance (\%)}) - (\text{Reflectance (1) (\%)})$$

[Evaluation criteria]

A: The decrease (1) is 3.0% or less.
B: The decrease (1) is more than 3.0% and 3.5% or less.
C: The decrease (1) is more than 3.5%.

(Decrease (2) in reflectance after long-term heating)

A polyester composition obtained in each of the Examples and Comparative Examples was used and injection molded (mold temperature: 140°C) at a cylinder temperature higher by about 20°C than the melting point of the polyester; and a test piece of a size of 1 mm in thickness, 40 mm in width, and 100 mm in length was fabricated. This test piece was subjected to a heat treatment at 120°C in a hot-air dryer for 600 hours. The reflectance (2) of light of a wavelength of 460 nm of the test piece after the heat treatment was determined by a spectrophotometer (U-4000), manufactured by Hitachi, Ltd., and the decrease (2) in reflectance after long-term heating was determined according to the following equation. In addition, the decrease (2) was evaluated according to the following evaluation criteria. The results are shown in Tables 1 and 2.

$$\text{Decrease (2) (\%)} = (\text{Initial reflectance (\%)}) - (\text{Reflectance (2) (\%)})$$

[Evaluation criteria]

A: The decrease (2) is 5.5% or less.
B: The decrease (2) is more than 5.5% and 6.0% or less.
C: The decrease (2) is more than 6.0%.

(Reflectance after light irradiation)

A polyester composition obtained in each of the Examples and Comparative Examples was used and injection molded (mold temperature: 140°C) at a cylinder temperature higher by about 20°C than the melting point of the polyester; and a test piece of a size of 100 mm in length, 40 mm in width, and 1 mm in thickness was fabricated. This test piece was installed at a distance of 25 cm from an upper part quartz glass surface of a light fastness tester (Super Win Mini, manufactured by Daipla Wintes Co., Ltd., lamp: metal halide lamp) equipped with a KF-1 filter (manufactured by Daipla Wintes Co., Ltd., transmission wavelength region: 295 nm to 780 nm), and irradiated with light at 120°C for 1,500 hours. The illuminance in wavelengths of 300 to 400 nm at the installation position of the test piece was 10 $mW/cm^2$. The reflectance of light of a wavelength of 460 nm of the test piece after light irradiation was determined by a spectrophotometer (U-4000), manufactured by Hitachi, Ltd. The results are shown in Tables 1 and 2.

The respective components used in each of the Examples and Comparative Examples are as follows.

[Polyester (A)]

- A-1: Polycyclohexane dimethylene terephthalate having a structural unit derived from a dicarboxylic acid including 100 mol% of terephthalic acid and a structural unit derived from a diol including 100 mol% of 1,4-cyclohexanedimethanol having a trans-isomer ratio of 69% by mass (melting point: 290°C, weight average molecular weight = 6,500)
- A-2: Polycyclohexane dimethylene terephthalate having a structural unit derived from a dicarboxylic acid including 92 mol% of terephthalic acid and 8 mol% of isophthalic acid and a structural unit derived from a diol including 100 mol% of 1,4-cyclohexanedimethanol having a trans-isomer ratio of 72% by mass (melting point: 278°C, weight average molecular weight = 6,000)

[Titanium oxide (B)]

• B-1: Titanium dioxide (average particle diameter: 0.25 μm, refractive index: 2.71)

[Phenolic antioxidant (C)]

- C-1: 3,9-Bis[2-[3-(3-t-butyl-4-hydroxy-5-methylphenyl)propionyloxy]-1,1-dimethylethyl ]-2,4,8,10-tetraoxaspiro[5.5]undecane (represented by the following formula (8), a trade name: "Sumilizer GA-80", manufactured by Sumitomo Chemical Co., Ltd.)

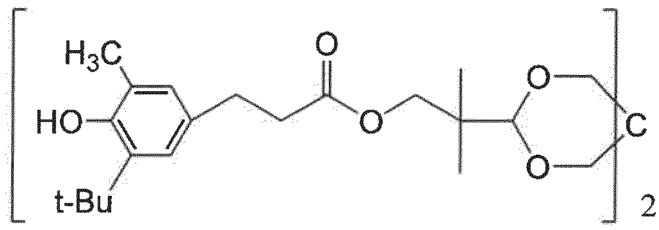

(8)

- C-2: Pentaerythrityl-tetrakis[3-(3,5-di-t-butyl-4-hydroxyphenyl)propionate] (represented by the following formula (9), a trade name: "IRGANOX 1010", manufactured by BASF Japan Ltd.)

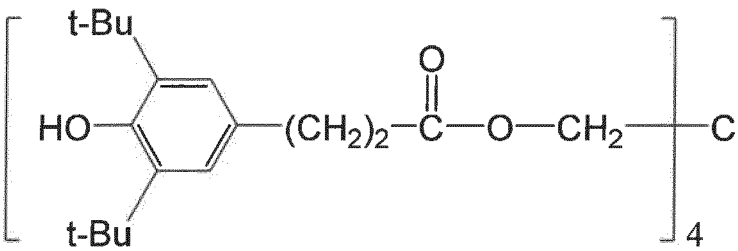

(9)

- C-3: 2,2-Thio-diethylenebis[3-(3,5-di-t-butyl-4-hydroxyphenyl)propionate] (represented by the following formula (10), a trade name: "IRGANOX 1035", manufactured by BASF Japan Ltd.)

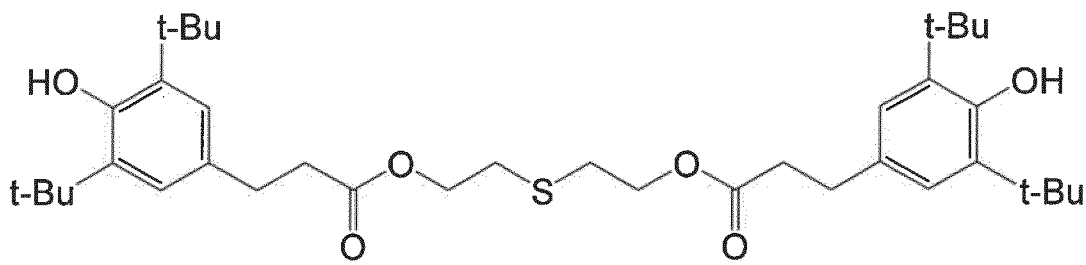

(10)

• C-4: n-Octadecyl-3-(3,5-di-t-butyl-4-hydroxyphenyl)propionate (represented by the following formula (11), a trade name: "IRGANOX 1076", manufactured by BASF Japan Ltd.)

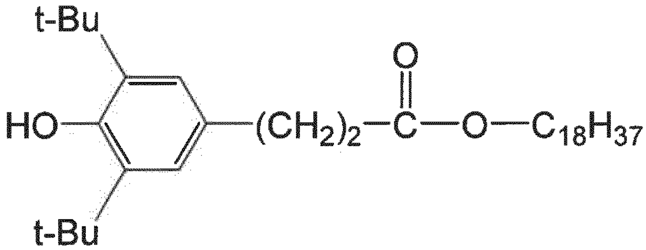

(11)

• C- 5: N,N'-Hexamethylenebis[(3-(3,5-di-t-butyl-4-hydroxyphenyl)propionamide] (represented by the following formula (12), a trade name: "IRGANOX 1098", manufactured by BASF Japan Ltd.)

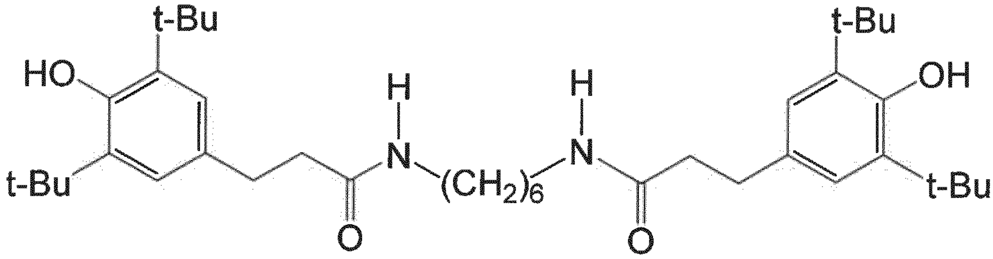

(12)

[Phosphorus-based antioxidant (D)]

• D-1: Tetrakis(2,4-di-t-butylphenyl)-4,4'-biphenylene diphosphonite (represented by the following formula (13), a trade name: "Hostanox P-EPQ", manufactured by Clariant Japan K.K.)

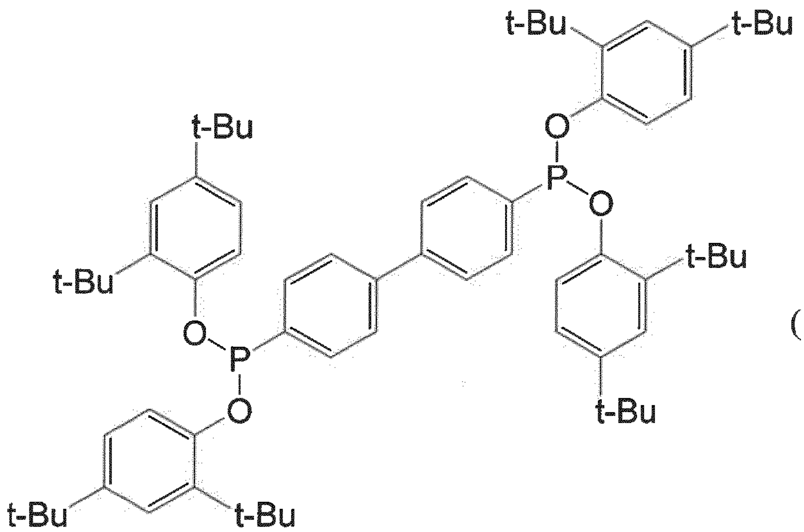

(13)

• D-2: Tris(2,4-di-t-butylphenyl)phosphite (represented by the following formula (14), a trade name: "IRGAFOS 168", manufactured by BASF Japan Ltd.)

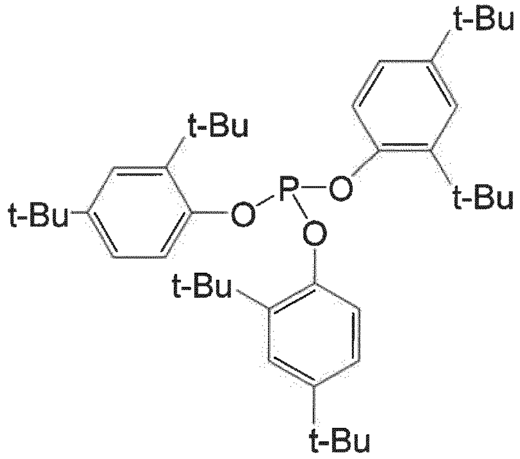

(14)

• d-3: 3,9-Bis(2,6-di-t-butyl-4-methylphenoxy)-2,4,8,10-tetraoxa-3,9-diphosphaspiro[5.5] undecane (a trade name: "Adekastab PEP-36", manufactured by Adeka Corporation)
• d-4: 3,9-Bis(octadecyloxy)-2,4,8,10-tetraoxa-3,9-diphosphaspiro[5.5]undecane (a trade name: "Adekastab PEP-8", manufactured by Adeka Corporation)
• d-5: 2,2'-Methylenebis(4,6-di-t-butylphenyl) 2-ethylhexyl phosphite (a trade name: "Adekastab HP-10", manufactured by Adeka Corporation)

[Reinforcing material (E)]

• E-1: Glass fiber (a trade name: "CS3J256S", manufactured by Nitto Boseki Co., Ltd., average fiber diameter: 11 μm, average fiber length: 3 mm, circular cross-section)

[Light stabilizer (F)]

• F-1: N,N'-Bis(2,2,6,6-tetramethyl-4-piperidinyl)-1,3-benzenedicarboxamide (a trade name: "Nylostab S-EED", manufactured by Clariant Japan K.K.)

[Other components]

- Release agent: Polypropylene, a general type (a trade name: "Hi-Wax NP055", manufactured by Mitsui Chemicals, Inc.)
- Nucleating agent: Talc (a trade name: "Talc PKP80", manufactured by Fuji Talc Industrial Co., Ltd.)

Examples 1 to 16 and Comparative Examples 1 to 14

100 parts by mass of the polyester (A-1) or (A-2) was dry blended with 33 parts by mass of the titanium dioxide (B-1), 0.5 parts by mass of the aforementioned release agent, 0.17 parts by mass of the aforementioned nucleating agent, and the phenolic antioxidant, the phosphorus-based antioxidant, and the light stabilizer (F-1) in amounts shown in Tables 1 and 2, respectively; the obtained mixture was fed from a hopper of a twin-screw extruder (screw diameter: 32 mm, L/D = 30, rotation number: 150 rpm); at the same time, 33 parts by mass of the reinforcing material (E-1) was added from a side feeder and melt kneaded; the melt was extruded in a strand form; and the resultant was cut by using a pelletizer, thereby obtaining a pellet-shaped polyester composition. The obtained polyester composition was used, and test pieces in predetermined shapes were fabricated and used for the evaluations. The results are shown in Tables 1 and 2.

Table 1

| | | Polyester (A) | Antioxidant | | | | | Light stabilizer (F) | Initial reflectance | | Reflectance after heating | | | | Reflectance after light irradiation |
|---|---|---|---|---|---|---|---|---|---|---|---|---|---|---|---|
| | | | Phenolic antioxidant (C) | | Phosphorus-based antioxidant (D) | | Mass ratio [component (C) /component (D)] | | | | Heating conditions (170°C, 5 hr) | | Heating conditions (120°C, 600 hr) | | Irradiation condition 1,500 h) |
| | | | Kind | Amount (parts)* | Kind | Amount (parts)* | | Amount (parts)* | (%) | Evaluation | Decrease (1) (%) | Evaluation | Decrease (2) (%) | Evaluation | (%) |
| Example | 1 | A-1 | C-1 | 0.17 | D-1 | 0.17 | 1.00 | 0.50 | 94.2 | A | 2.1 | A | 3.2 | A | 87.5 |
| | 2 | A-1 | C-1 | 0.17 | D-1 | 0.17 | 1.00 | 0.17 | 94.0 | A | 1.0 | A | 2.3 | A | 86.1 |
| | 3 | A-1 | C-2 | 0.17 | D-1 | 0.17 | 1.00 | 0.17 | 94.4 | A | 1.1 | A | 2.9 | A | 86.4 |
| | 4 | A-1 | C-3 | 0.17 | D-1 | 0.17 | 1.00 | 0.17 | 94.0 | A | 1.2 | A | 3.2 | A | 86.7 |
| | 5 | A-1 | C-4 | 0.17 | D-1 | 0.17 | 1.00 | 0.17 | 94.4 | A | 1.3 | A | 2.3 | A | 86.9 |
| | 6 | A-1 | C-5 | 0.17 | D-1 | 0.17 | 1.00 | 0.17 | 94.4 | A | 2.5 | A | 3.8 | A | 86.8 |
| | 7 | A-1 | C-5 | 0.17 | D-2 | 0.17 | 1.00 | 0.17 | 94.6 | A | 1.6 | A | 3.7 | A | 87.4 |
| | 8 | A-1 | C-5 | 0.17 | D-2 | 0.17 | 1.00 | 0 | 94.3 | A | 1.0 | A | 2.2 | A | 86.6 |
| | 9 | A-1 | C-5 | 0.17 | D-2 | 0.17 | 1.00 | 0.50 | 94.2 | A | 2.6 | A | 5.5 | A | 86.8 |
| | 10 | A-1 | C-2 | 0.17 | D-1 | 0.50 | 0.33 | 0.17 | 94.9 | A | 1.9 | A | 3.6 | A | 87.2 |
| | 11 | A-1 | C-2 | 0.50 | D-1 | 0.17 | 3.00 | 0.17 | 94.3 | A | 0.6 | A | 2.3 | A | 87.8 |
| | 12 | A-1 | C-2 | 0.50 | D-1 | 0.50 | 1.00 | 0.17 | 94.7 | A | 1.1 | A | 2.7 | A | 86.7 |
| | 13 | A-1 | C-1 | 0.17 | D-1 | 0.50 | 0.33 | 0.17 | 94.2 | A | 1.6 | A | 2.5 | A | 86.8 |
| | 14 | A-1 | C-1 | 0.50 | D-1 | 0.17 | 3.00 | 0.17 | 94.8 | A | 1.3 | A | 2.7 | A | 87.5 |
| | 15 | A-1 | C-1 | 0.50 | D-1 | 0.50 | 1.00 | 0.17 | 94.9 | A | 0.9 | A | 3.0 | A | 86.7 |
| | 16 | A-2 | C-1 | 0.17 | D-1 | 0.17 | 1.00 | 0.17 | 94.1 | A | 1.8 | A | 3.0 | A | 88.1 |

*: Content on the basis of 100 parts by mass of the polyester (A) (parts by mass)

Table 2

| | | Polyester (A) | Antioxidant | | | | | Light stabilizer (F) | Initial reflectance | | Reflectance after heating | | | | Reflectance after light irradiation |
|---|---|---|---|---|---|---|---|---|---|---|---|---|---|---|---|
| | | | Phenolic antioxidant (C) | | Phosphorus-based antioxidant (D) | | Mass ratio [component (C) /component (D)] | | | | Heating conditions (170°C, 5 hr) | | Heating conditions (120°C, 600 hr) | | Irradiation condition (1,500 h) |
| | | | Kind | Amount (parts)* | Kind | Amount (parts)* | | Amount (parts)* | (%) | Evaluation | Decrease (1) (%) | Evaluation | Decrease (2) (%) | Evaluation | (%) |
| Comparative Example | 1 | A-1 | - | - | D-2 | 0.17 | - | 0.50 | 92.3 | C | 2.9 | A | 2.4 | A | 85.7 |
| | 2 | A-1 | - | - | D-1 | 0.17 | - | 0.50 | 93.7 | B | 3.2 | B | 3.3 | A | 86.9 |
| | 3 | A-1 | - | - | d-3 | 0.17 | - | 0.50 | 94.1 | A | 5.0 | C | 6.4 | C | 88.0 |
| | 4 | A-1 | - | - | d-5 | 0.17 | - | 0.50 | 92.9 | C | 3.4 | B | 2.7 | A | 86.8 |
| | 5 | A-1 | - | - | d-4 | 0.17 | - | 0.50 | 93.7 | B | 5.5 | C | 3.7 | A | 87.2 |
| | 6 | A-1 | C-5 | 0.17 | - | - | - | 0.50 | 93.8 | B | 3.4 | B | 5.3 | A | 87.5 |
| | 7 | A-1 | C-1 | 0.17 | - | - | - | 0.50 | 93.9 | B | 3.8 | C | 5.2 | A | 86.2 |
| | 8 | A-1 | C-2 | 0.17 | D-1 | 1.50 | 0.11 | 0.17 | 93.2 | B | 2.0 | A | 6.0 | B | 85.1 |
| | 9 | A-1 | C-2 | 1.50 | D-1 | 0.17 | 9.00 | 0.17 | 93.5 | B | 4.3 | C | 6.7 | C | 85.3 |
| | 10 | A-1 | C-2 | 1.50 | D-1 | 1.50 | 1.00 | 0.17 | 93.6 | B | 3.2 | B | 4.4 | A | 84.4 |
| | 11 | A-1 | C-1 | 0.83 | D-1 | 0.83 | 1.00 | 0.17 | 94.2 | A | 4.0 | C | 5.4 | A | 85.3 |
| | 12 | A-1 | C-1 | 0.17 | d-4 | 0.17 | 1.00 | 0.17 | 94.2 | A | 3.2 | B | 3.9 | A | 85.6 |
| | 13 | A-2 | C-1 | 0.17 | - | - | - | 0.50 | 93.5 | B | 4.0 | C | 5.3 | A | 86.0 |
| | 14 | A-1 | C-1 | 0.17 | d-5 | 0.17 | 1.00 | 0.17 | 93.2 | B | 3.5 | B | 4.8 | A | 85.9 |

*: Content on the basis of 100 parts by mass of the polyester (A) (parts by mass)

As shown in Tables 1 and 2, all of the polyester compositions of Examples 1 to 16 are high in the initial reflectance and small in the decrease in the reflectance against light of a wavelength of 460 nm even after the heat treatment, as compared with those of Comparative Examples 1 to 14. Furthermore, all of the polyester compositions of Examples 1 to 16 are 86% or more in the reflectance against light of a wavelength of 460 nm after the light irradiation in an ultraviolet wavelength region. Accordingly, the polyester composition of the present invention is able to provide an LED reflection plate which is free from the decrease of the light reflectance even in the production process or use environment of the LED package and has good optical properties, and a light-emitting device including the foregoing reflection plate and a lighting fixture including the foregoing light-emitting device make it possible to exhibit excellent optical properties and long life.

Industrial Applicability

In accordance with the present invention, it is possible to provide a polyester composition for an LED reflection plate which has a high light reflectance, is small in the decrease of the light reflectance even after being exposed to heat or light, and is able to maintain a high light reflectance, an LED reflection plate composed of the composition, and a light-emitting device including the reflection plate. The polyester composition of the present invention is suitable especially for an LED reflection plate for lighting fixtures.

Reference Signs List

1, 2, 3: Light-emitting device
10: Semiconductor light-emitting element
20: Substrate
30: Reflector (housing)
40: Sealing member
50: Package-form section
60: Sealing member
70: Substrate
71: Wiring
80: Lead frame

## Claims

1. A polyester composition for an LED reflection plate, comprising:

a polyester (A), a titanium oxide (B), a phenolic antioxidant (C), and a phosphorus-based antioxidant (D),
wherein the polyester (A) is a polyester having a structural unit derived from a dicarboxylic acid including 50 mol% or more of terephthalic acid and a structural unit derived from a diol including 50 mol% or more of 1,4-cyclohexanedimethanol;
the phosphorus-based antioxidant (D) contains three or more groups represented by the following formula (1) in a molecule thereof;
the content of the titanium oxide (B) is 20 to 90 parts by mass, and the content of the phenolic antioxidant (C) is 0.10 to 0.80 parts by mass, on the basis of 100 parts by mass of the polyester (A); and
the content of the phosphorus-based antioxidant (D) satisfies the following equation (I):

$$0.20 \leq \text{mass ratio [component (C)/component (D)]} \leq 5.00 \qquad \text{(I)}$$

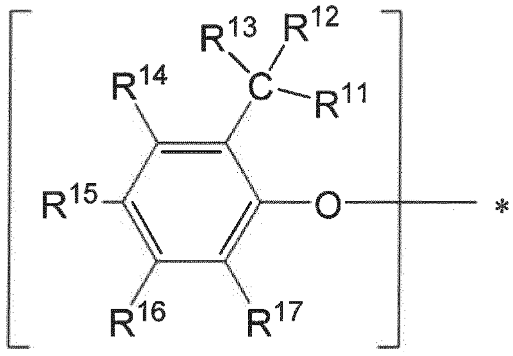

(1)

wherein $R^{11}$ to $R^{13}$ are each independently an alkyl group having 1 or 2 carbon atoms; $R^{14}$ to $R^{17}$ are each independently a hydrogen atom or an alkyl group having 1 to 10 carbon atoms; and * represents a bonding site with a phosphorus atom.

2. The polyester composition for an LED reflection plate according to claim 1, wherein the mass ratio of the phenolic antioxidant (C) to the phosphorus-based antioxidant (D) [component (C)/component (D)] satisfies the following equation (I'):

$$0.20 \leq \text{mass ratio [component (C)/component (D)]} \leq 3.00 \qquad (I') .$$

3. The polyester composition for an LED reflection plate according to claim 1 or 2, further comprising 5 to 50 parts by mass of a reinforcing material (E) on the basis of 100 parts by mass of the polyester (A).

4. The polyester composition for an LED reflection plate according to claim 3, wherein the reinforcing material (E) is a glass fiber.

5. The polyester composition for an LED reflection plate according to any one of claims 1 to 4, wherein the polyester (A) is a polycyclohexane dimethylene terephthalate having a structural unit derived from a dicarboxylic acid including 75 to 100 mol% of terephthalic acid and a structural unit derived from a diol including 75 to 100 mol% of 1,4-cyclohexanedimethanol.

6. The polyester composition for an LED reflection plate according to any one of claims 1 to 5, wherein the phosphorus-based antioxidant (D) is at least one selected from the group consisting of phosphites and phosphonites, each having three or more groups represented by the formula (1) in a molecule thereof.

7. The polyester composition for an LED reflection plate according to any one of claims 1 to 6, wherein the phenolic antioxidant (C) contains at least one group represented by the following formula (2) in a molecule thereof:

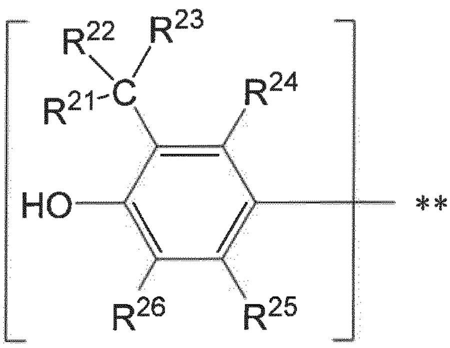

(2)

wherein $R^{21}$ to $R^{23}$ are each independently an alkyl group having 1 or 2 carbon atoms; $R^{24}$ to $R^{26}$ are each independently a hydrogen atom or an alkyl group having 1 to 10 carbon atoms; and ** represents a bonding site.

**8.** The polyester composition for an LED reflection plate according to claim 7, wherein the phenolic antioxidant (C) is at least one selected from the group consisting of phenolic antioxidants of a semi-hindered type or full-hindered type, which have the group represented by the formula (2) where $R^{21}$ to $R^{23}$ are all a methyl group and $R^{26}$ is a methyl group or a t-butyl group.

**9.** The polyester composition for an LED reflection plate according to any one of claims 1 to 8, further comprising a light stabilizer (F).

**10.** An LED reflection plate, comprising the polyester composition for an LED reflection plate according to any one of claims 1 to 9.

**11.** A light-emitting device, comprising the LED reflection plate according to claim 10.

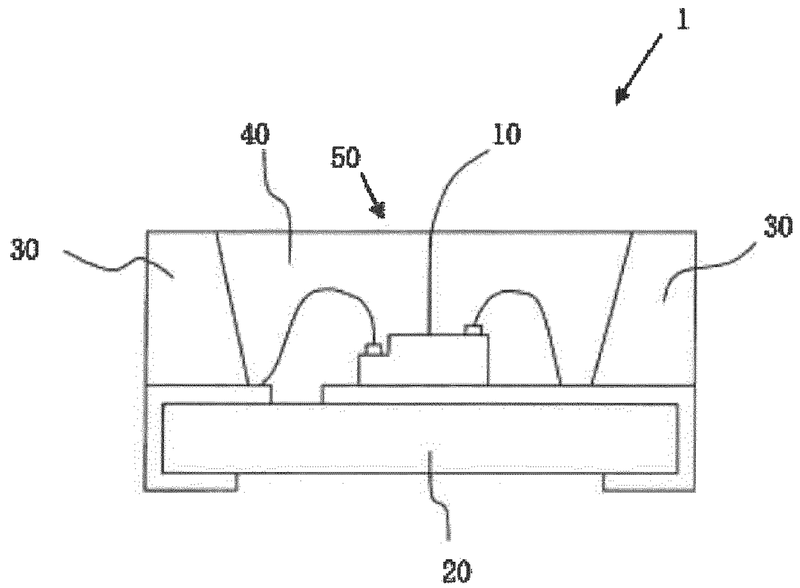


Fig. 1

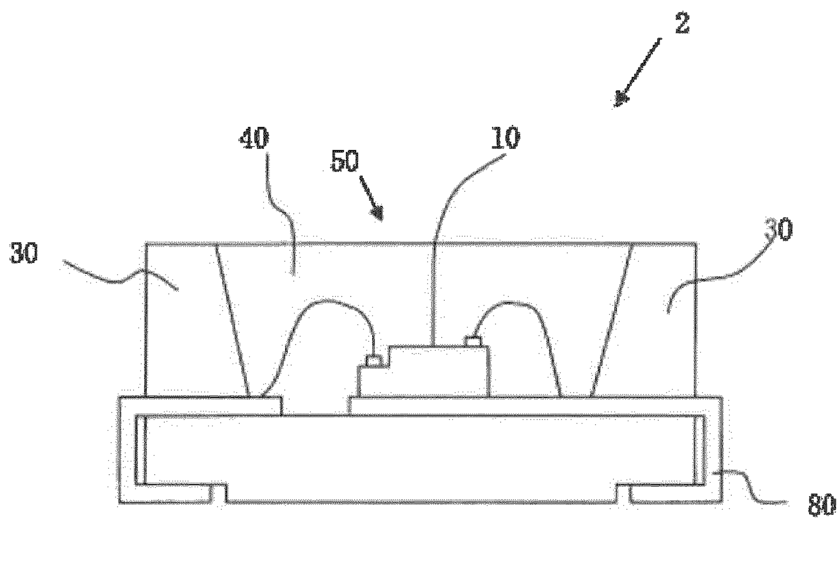


Fig. 2

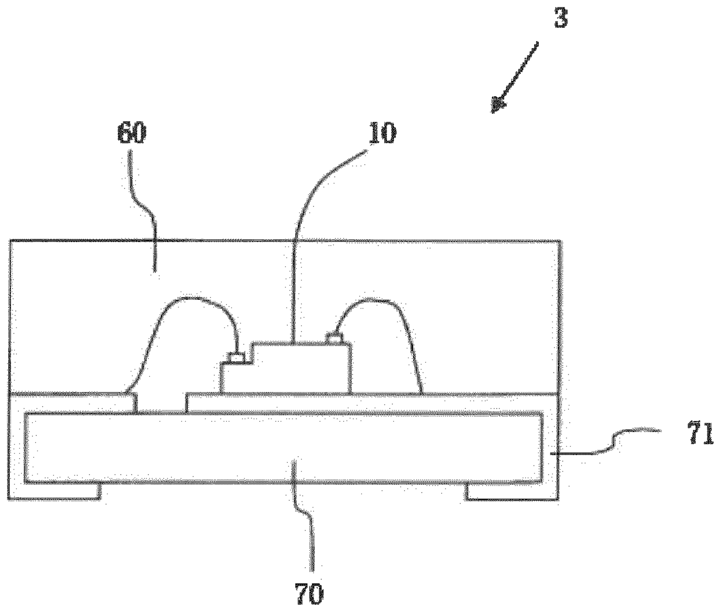


Fig. 3

**INTERNATIONAL SEARCH REPORT**

International application No. PCT/JP2016/083927

A. CLASSIFICATION OF SUBJECT MATTER
*H01L33/60*(2010.01)i, *C08K3/22*(2006.01)i, *C08K5/00*(2006.01)i, *C08K5/13*(2006.01)i, *C08K5/524*(2006.01)i, *C08K5/5393*(2006.01)i, *C08K7/14*(2006.01)i, *C08L67/02*(2006.01)i

According to International Patent Classification (IPC) or to both national classification and IPC

B. FIELDS SEARCHED

Minimum documentation searched (classification system followed by classification symbols)
H01L33/00-33/64

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2017 |
| Kokai Jitsuyo Shinan Koho | 1971-2017 | Toroku Jitsuyo Shinan Koho | 1994-2017 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2015-93943 A (Toyobo Co., Ltd.), 18 May 2015 (18.05.2015), entire text; all drawings (Family: none) | 1-11 |
| A | JP 2014-148615 A (Toyobo Co., Ltd.), 21 August 2014 (21.08.2014), entire text; all drawings (Family: none) | 1-11 |
| A | JP 2013-60587 A (Mitsubishi Rayon Co., Ltd.), 04 April 2013 (04.04.2013), entire text; all drawings (Family: none) | 1-11 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 08 February 2017 (08.02.17) | 21 February 2017 (21.02.17) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (January 2015)

**INTERNATIONAL SEARCH REPORT**

International application No.
PCT/JP2016/083927

C (Continuation). DOCUMENTS CONSIDERED TO BE RELEVANT

| Category* | Citation of document, with indication, where appropriate, of the relevant passages | Relevant to claim No. |
|---|---|---|
| A | WO 2015/146988 A1 (Daicel Corp.), 01 October 2015 (01.10.2015), entire text; all drawings & TW 201542673 A | 1-11 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2011027562 A
- JP 2009507990 A